# EUROPÄISCHE PATENTSCHRIFT

(11) **EP 3 437 036 B1**
(45) Veröffentlichungstag und Bekanntmachung des Hinweises auf die Patenterteilung: **24.11.2021**
(21) Anmeldenummer: 17717322.6
(22) Anmeldetag: 06.04.2017
(51) Int. Cl.: G06Q 10/06, G06Q 50/08, G09B 9/04, G09B 19/16

(54) **VERFAHREN UND VORRICHTUNG ZUM PLANEN UND/ODER STEUERN UND/ODER SIMULIEREN DES BETRIEBS EINER BAUMASCHINE**
METHOD AND DEVICE FOR PLANNING AND/OR CONTROLLING AND/OR SIMULATING THE OPERATION OF A CONSTRUCTION MACHINE
PROCÉDÉ ET DISPOSITIF POUR PLANIFIER ET/OU COMMANDER ET/OU SIMULER LE FONCTIONNEMENT D'UN ENGIN DE CHANTIER

(30) Priorität: 08.04.2016 DE 102016004382
(43) Veröffentlichungstag der Anmeldung: 06.02.2019
(60) Teilanmeldung: 21180144.4
(73) Patentinhaber: Liebherr-Werk Biberach GmbH, 88400 Biberach an der Riss (DE)
(72) Erfinder: BRAMBERGER, Robert, 82293 Mittelstetten / Vogach (DE)
(74) Vertreter: Thoma, Michael
(86) Internationale Anmeldenummer: PCT/EP2017/000435
(87) Internationale Veröffentlichungsnummer: WO 2017/174195

(56) Entgegenhaltungen:
- WO-A1-2016/019158
- WO-A2-2013/006625
- DE-A1-102013 212 686

## Beschreibung

Die vorliegende Erfindung betrifft ein Verfahren sowie eine Vorrichtung zum Planen und/oder Steuern und/oder Simulieren des Betriebs einer Baumaschine, insbesondere in Form eines Krans wie Turmdrehkran, unter Verwendung eines Bauwerkdatenmodells, das digitale Informationen über ein zu errichtendes und/oder zu bearbeitendes Bauwerk enthält. Die Erfindung betrifft dabei auch die Baumaschine selbst, die an ein solches Bauwerkdatenmodell anbindbar ist und/oder unter Verwendung eines solchen Bauwerkdatenmodells steuerbar ist. Schließlich betrifft die Erfindung auch einen Simulator und/oder eine Fernsteuerung zum Simulieren und/oder Fernsteuern einer Baumaschine unter Verwendung eines solchen Bauwerkdatenmodells.

Für das Planen, Errichten, Bearbeiten und Überprüfen von Bauwerken werden in jüngerer Zeit digitale Bauwerkdatenmodelle für alle am Bauwerk beteiligten Gewerke verwendet. Die dazu entwickelte Methode ist unter dem Begriff Building Information Modelling bekannt. In dieser als BIM-Modell bezeichneten Datenbasis sind digitale Informationen über das zu errichtende bzw. zu bearbeitende Bauwerk enthalten. Solche Bauwerkdatenmodelle oder BIM-Modelle sind in der Regel computerlesbare Dateien oder Dateikonglomerate und ggfs. verarbeitende Computerprogramm-Bausteine zum Verarbeiten solcher Dateien, in denen Informationen und Charakteristika, die das zu errichtende bzw. zu bearbeitende Bauwerk und dessen relevante Eigenschaften in Form digitaler Daten beschreiben. Insbesondere können solche Bauwerkdatenmodelle zwei-, drei- oder mehrdimensionale CAD-Daten zur Visualisierung des Bauwerks und/oder dessen Bauwerksteile enthalten, aber auch andere relevante Informationen über das Bauwerk, beispielsweise dessen Zeitplan zu seiner Errichtung, Informationen über die umgebende Infrastruktur wie Zufahrtsstraßen, Energie- und Wasserversorgung, oder logistische Informationen über benötigte Hilfsmittel für die Errichtung bzw. Bearbeitung des Bauwerks, umfassen. Als charakteristische Bauwerksdaten sind oft Bauwerksgrößen wie Bauvolumen, Bauwerkshöhe, Erstreckungsmaße im Aufriss, Materialvolumina wie benötigtes Betonvolumen, Ziegelsteinvolumen etcetera, oder Bauteilgewichte von einzelnen Bauwerkskomponenten wie Stahlträgern, Fertigbauteilen oder ähnliches enthalten. Das Bauwerkdatenmodell und seine Dateien bzw. das Dateienkonglomerat ist dabei häufig verschickbar und/oder netzwerkfähig, um verschiedenen Baubeteiligten zur Verfügung zu stehen.

Mit Hilfe solcher Bauwerkdatenmodelle werden viele Prozesse bei der Errichtung eines Bauwerks computergestützt bearbeitet, wobei beispielsweise in der klassischen Bauplanung ein Architekt einen Entwurf erstellt und diesen mit Hilfe von CAD-Systemen zeichnet, woraufhin dann zur Kostenkalkulation auf Basis der CAD-Zeichnungen eine Mengenermittlung erstellt werden kann oder die Pläne anderen Fachingenieuren, Brandschutzgutachtern oder Behörden vorgelegt werden können. Treten Planungsänderungen auf, werden die Zeichnungen geändert und mit den Beteiligten abgeglichen, wird die Mengenermittlung angepasst und die Kostenkalkulation überarbeitet, was sich alles unter Zuhilfenahme des integrierten BIM-Modell deutlich vereinfacht und von Softwarebausteinen, die auf die Daten des Bauwerkdatenmodells zugreifen können, teilweise automatisch erledigt wird.

In diesem Kontext wurde bereits vorgeschlagen, Daten betreffend den Betrieb eines Krans an ein BIM- bzw. Bauwerkdatenmodell anzubinden. Die Schrift WO 2016/019158 A1 beschreibt beispielsweise ein Verfahren, mittels dessen ein BIM-Modell durch Kranbetriebsdaten aktualisiert wird, wobei anhand der durch den Kran zu versetzenden Bauteile eine Zeitschiene bzw. ein Zeitplan generiert wird, die die benötigten Kraneinsätze beinhaltet und in das Datenmodell der BIM-Umgebung integriert wird. Das Datenmodell kann dann anhand der generierten Zeitschiene weitere BIM-Funktionen aktualisieren.

Ferner beschreibt die Schrift WO 2013/006625 A1 ein Verfahren zum Manövrieren eines Krans innerhalb einer Baustelle unter Zuhilfenahme von Daten aus einem BIM-Modell, wobei einerseits globale 3D-Koordinaten des Kranhakens, die mit Hilfe von absoluten Positionssensoren bestimmt werden, und andererseits globale 3D-Koordinaten, die das zu errichtende Bauwerk und die Position der Bauwerksteile charakterisieren und im BIM-Modell abgelegt sind, miteinander abgeglichen werden.

DE 10 2013 212686 A1 offenbart eine Parametrisierung einer Baumaschine, anhand eines virtuellen Modells, welches mit Landschafts- oder Infrastrukturdaten aufbereitet wird sowie eine Begrenzung des Arbeitsbereichs der Baumaschine in Verbindung mit der Steuerung solcher Baumaschine.

Im Ergebnis ist der funktionale Zugewinn der bislang vorgesehenen Anbindung eines Krans an das BIM-Modell jedoch begrenzt. Insbesondere konnten bislang keine durchschlagenden Vorteile bei der Steuerung von Baumaschinen wie Kranen oder Baggern und deren Handhabung durch BIM-Modelle erzielt werden.

Der vorliegenden Erfindung liegt daher die Aufgabe zugrunde, eine verbesserte Integration von Baumaschinen und deren Betrieb in Bauwerkdatenmodelle und/oder eine verbesserte Anbindung von Baumaschinen an solche Bauwerkdatenmodelle zu schaffen, die Nachteile des Standes der Technik vermeiden und letzteren in vorteilhafter Weise weiterbilden. Insbesondere soll eine effizientere und sicherere Steuerung von Baumaschinen durch eine verbesserte Anbindung an BIM-Modelle erzielt werden.

Erfindungsgemäß wird die genannte Aufgabe durch ein Verfahren gemäß Anspruch 1, eine Vorrichtung gemäß Anspruch 8, eine Baumaschine gemäß Anspruch 16, und ein Softwareprogramm-Produkt gemäß Anspruch 17 gelöst. Bevorzugte Ausgestaltungen der Erfindung sind Gegenstand der abhängigen Ansprüche.

Es wird also nach einem Aspekt der Erfindung vorgeschlagen, ein Maschinendatenmodell, in dem digitale Informationen über verschiedene Baumaschinenmodelle enthalten sind, an das Bauwerkdatenmodell bzw. das BIM-Modell anzubinden und Charakteristika der zur Verfügung stehenden Baumaschinen bereits bei der Planung zu berücksichtigen. Das genannte Maschinendatenmodell kann dabei in Form eines Software-Bausteins oder einer App bereitgestellt werden, der/die eine Schnittstelle zur Kommunikation mit dem Bauwerkdatenmodell besitzt und beispielsweise von einem Server oder einem Software-Store heruntergeladen oder auch auf einem Datenträger gespeichert sein kann.

Dabei kann mittels des Maschinendatenmodells ein automatisches Auswählen einer für die Errichtung und/oder Bearbeitung des jeweiligen Bauwerks geeigneten Baumaschine anhand digitaler Informationen aus dem Bauwerkdatenmodell und aus dem Maschinendatenmodells erfolgen, wobei hierfür ein automatisches Identifizieren und Auslesen von relevanten Informationen aus dem Bauwerkdatenmodell anhand von Kriterien erfolgt, die von dem Maschinendatenmodell vorgegeben werden und Maschinendaten betreffen, in denen sich die verschiedenen Baumaschinenmodelle voneinander unterscheiden. Anhand eines automatischen Vergleichens der ausgelesenen Informationen aus dem Bauwerkdatenmodell mit den Maschinendaten verschiedener Baumaschinen aus dem Maschinendatenmodell erfolgt sodann das automatische Auswählen der geeigneten Baumaschine.

Die die genannten Funktionen realisierenden Bausteine können insbesondere in Form von Software-Tools in das Maschinendatenmodell integriert sein, ggfs. aber auch in dem Bauwerkdatenmodell realisiert sein. Bei Integration in das anbindbare Maschinendatenmodell kann die gesamte Funktionalität für das automatische Auswählen der passenden Baumaschine von dem herunterladbaren und/oder einspielbaren Software-Tool, welches das Maschinendatenmodell realisiert, bereitgestellt werden und insofern mit einem BIM- bzw. Bauwerkdatenmodell gearbeitet werden, das hierfür lediglich eine entsprechende Schnittstelle benötigt, über die das ergänzende Software-Tool angebunden werden kann.

Die relevanten Informationen aus dem Bauwerkdatenmodell, die für die Auswahl der Baumaschine benötigt werden und von einem Identifikations- und/oder Auslesemodul identifiziert und ausgelesen werden, können verschiedene Bauwerkscharakteristika wie beispielsweise die Bauwerkshöhe, das Gewicht des schwersten zu versetzenden Bauteils, die Fläche und/oder die Querschnittserstreckung des Bauwerks im Aufriss und/oder die maximale Entfernung zwischen einer im BIM abgelegten Bauteilanlieferungsstation und einem Bauteilbestimmungsort, an dem das jeweilige Bauteil verbaut werden soll, umfassen. Diese identifizierten und ausgelesenen Bauwerkscharakteristika können von einem Vergleichsmodul dann mit relevanten Informationen aus dem Maschinendatenmodell verglichen werden, wobei die relevanten Maschineninformationen insbesondere folgende Informationen umfassen können: Maschinenhubhöhe, maximale Maschinentraglast und/oder Maschinenreichweite. Soll beispielsweise ein für das Bauwerk geeigneter Kran ausgewählt werden, kann ein Kran gewählt werden, dessen Hubhöhe für die Bauwerkshöhe ausreicht, dessen Traglast für das Gewicht des schwersten zu versetzenden Bauteils ausreicht und dessen Reichweite für die Querschnittserstreckung des Bauwerks im Aufriss und/oder die maximale Entfernung zwischen der Bauteilanlieferungsstation und dem Bauteilbestimmungsort ausreicht. Sind im Maschinendatenmodell mehrere Krane enthalten, die die genannten Kriterien erfüllen, kann der kleinste Kran ausgewählt werden, der die genannten Anforderungen erfüllt und sozusagen den kleinsten Überschuß hinsichtlich der Kranleistungen besitzt.

Gemäß einem weiteren Aspekt der vorliegenden Erfindung wird die Anbindung des Maschinendatenmodells an das Bauwerkdatenmodell auch dazu genutzt, um den Aufstellort der Baumaschine, insbesondere die Position des Krans, relativ zu dem zu errichtenden bzw. zu bearbeitenden Bauwerk automatisch zu bestimmen und/oder automatisch zu überprüfen. Ist eine Baumaschine ausgewählt, was in der vorgenannten Weise automatisiert durch das beschriebene Auswahlmodul oder alternativ auch händisch vom Planer selbst erfolgen kann, kann ein Positionsbestimmungsmodul anhand relevanter Maschinendaten, die aus dem Baumaschinenmodell ausgelesen werden und beispielsweise die Reichweite und/oder die Hubhöhe und/oder den Kollisions- und/oder Arbeitsbereich der Baumaschine umfassen können, sowie anhand relevanter Bauwerksdaten, die aus dem Bauwerksdatenmodell ausgelesen werden und beispielsweise Bauwerksbemaßungen und/oder-konturen und/oder Baustellen-Topographiedaten und/oder Zufahrtswege und/oder Material-Anlieferungsstationen umfassen können, automatisch einen geeigneten Aufstellort für die Baumaschine bestimmen. Alternativ oder zusätzlich kann das genannte Positions- oder Aufstellort-Bestimmungsmodul eine eventuell händisch vom Planer festgelegten Position der Baumaschinen anhand der genannten Kriterien überprüfen, insbesondere dahingehend, ob bei dem bestimmten Aufstellort die Reichweite bzw. der Arbeitsort der Baumaschine für die von der Baumaschine auszuführenden Arbeiten ausreichend ist und/oder ob Kollisionen des Arbeitsbereichs der Baumaschine mit Bauwerkskonturen und/oder anderen topografischen Gegebenheiten der Baustelle wie beispielsweise Bäumen oder Nachbargebäuden auftreten, um dann ggfs. den Aufstellort der Baumaschine freizugeben oder einen alternativen Aufstellort vorzuschlagen.

Nach erfolgreicher Bestimmung und/oder Überprüfung des Maschinenaufstellorts kann das BIM- bzw. Bauwerkdatenmodell von dem genannten Aufstellort-Bestimmungsmodul bezüglich des Aufstellort entsprechend aktualisiert werden.

Gemäß der Erfindung kann das Aufstellort-Bestimmungsmodul anhand der vorgenannten Kollisionsprüfung auch automatisch den Arbeitsbereich der jeweils ausgewählten Baumaschine automatisch begrenzen und das Bauwerkdatenmodell durch die festgelegten Arbeitsbereichsbeschränkungen aktualisieren. Wie noch erläutert wird, kann die Baumaschinen-Steuervorrichtung hinsichtlich einer Arbeitsbereichsbegrenzungs-Funktion entsprechend angepaßt bzw. parametrisiert werden.

Gegebenenfalls zusätzlich zu einer solchen automatischen Auswahl und/oder Überprüfung der Arbeitsposition der Baumaschine kann ein Logistik-Modul anhand digitaler Informationen aus dem Bauwerkdatenmodell die Reihenfolge und/oder die Zeitpunkte der Anlieferung von Teilen der ausgewählten Baumaschine und/oder die für die Anlieferung benötigten Transporteinheiten automatisch festlegen. Das genannte Logistik-Modul kann hierbei ebenfalls in Form eines Software-Tools und/oder eines Funktionsbausteins in das Baumaschinenmodell integriert sein, ggfs. aber als separater Baustein auch an das Bauwerkdatenmodell angebunden werden. Insbesondere können durch das Logistik-Modul unter Zuhilfenahme der Daten aus dem Bauwerkdatenmodell sog. Kolli-Listen oder Transportlisten automatisert erstellt werden.

Die Reihenfolge und/oder die Zeitpunkte der Anlieferung von Teilen kann hierbei unter Berücksichtigung der für das Bauwerk auszuführenden Arbeiten und/oder des Fortgangs und/oder Status des Bauwerks festgelegt werden, die als digitale Informationen im Bauwerkdatenmodell abgelegt sein können. Zusätzlich zu den genannten Informationen aus dem Bauwerkdatenmodell kann das Logistik-Modul auch relevante Informationen aus dem Maschinendatenmodell berücksichtigen, insbesondere relevante Informationen zu der ausgewählten Baumaschine wie beispielsweise deren Zerlegbarkeit und/oder des Gewichts der Maschinenbauteile und/oder der Größe der Maschinenbauteile und/oder der Aufstellreihenfolge der Maschinenbauteile. Wird beispielsweise ein Kran angeliefert, können Tieflader- und/oder Containereinheiten in passender Größe und/oder passender Traglast in der Reihenfolge ausgewählt bzw. bestellt werden, mit Hilfe derer die Kranteile in der passenden Reihenfolge zum passenden Zeitpunkt an der Baustelle angeliefert werden können, ggfs. unter Berücksichtigung der dort vorhandenen Zufahrtswege.

Gemäß einem weiteren Aspekt der vorliegenden Erfindung wird auch ein Simulator zum Simulieren des Betriebs einer für die Errichtung und/oder Bearbeitung des Bauwerks ausgewählten Baumaschine an das Bauwerkdatenmodell angebunden, wobei bestimmte digitale Informationen aus dem Bauwerkdatenmodell für die Generierung der virtuellen Realität des Simulators genutzt werden können. Der Simulator kann hierbei eine Schnittstelle zur Anbindung des Bauwerkdatenmodells besitzen, wobei ein Identifikations- und/oder Auslesebaustein vorgesehen sein kann, um relevante Bauwerkscharakteristika wie Bauwerkkonturen, Umgebungskonturen oder andere verwendete Baumaschinen aus dem Bauwerkdatenmodell auszulesen und dem Generator zum Generieren der virtuellen Realität bereitzustellen, anhand derer dann die Animation der Baumaschine und/oder der Baumaschinenumgebung generiert werden kann, in der ein Maschinenführer dann bestimmte Maschinenaufgaben trainieren kann.

In Weiterbildung der Erfindung kann die Anbindung des BIM- bzw. Bauwerkdatenmodells an den Simulator dazu genutzt werden, um verschiedene Zustände und Bauphasen des zu errichtenden bzw. zu bearbeitenden Bauwerks anhand der digitalen Informationen aus dem Bauwerkdatenmodell auf der Anzeigeeinrichtung des Simulators darstellen bzw. als Animation anzeigen zu können, anhand derer dann ein Baumaschinenführer am Simulator bestimmte Sonderaufgaben wie beispielsweise Sonderhübe eines Krans trainieren kann. Für die Steuerung des Simulators und/oder die Generierung der virtuellen Realität am Simulator können auch Maschinendaten bereitgestellt und/oder eingespielt werden, die von dem vorgenannten Maschinendatenmodell bereitgestellt werden und die jeweils ausgewählte Baumaschine charakterisieren, um die virtuelle Realität am Simulator der für das Bauwerk ausgewählten Baumaschine anzupassen.

In Weiterbildung der Erfindung können auch mehrere Simulatoren an das Bauwerksdatenmodell angebunden werden, um das Zusammenspiel mehrerer Baumaschinen, die für die Errichtung bzw. Bearbeitung des Bauwerks ausgewählt sind, zu simulieren und zu trainieren. Solche mehreren Simulatoren können einerseits in der vorgenannten Weise digitale Informationen betreffend das Bauwerk beziehen, um die virtuelle Realität anhand der Bauwerksdaten aus dem Bauwerkdatenmodell zu generieren, beispielsweise verschiedene Bauphasen und Zustände des zu errichtenden Bauwerks. Andererseits können jeweils digitale Informationen aus dem Maschinendatenmodell eingespielt bzw. eingelesen werden, um die virtuellen Darstellungen an den Simulatoren an die jeweils verwendeten Baumaschinen anpassen zu können.

In vorteilhafter Weiterbildung der Erfindung wird dabei das Zusammenspiel der beiden Simulatoren durch einen übergeordneten Simulator-Steuerungsbaustein miteinander koordiniert, insbesondere derart, dass an dem einen Simulator veranlasste bzw. vorgenommene Maschinenaktionen wie beispielsweise Kranhübe an dem jeweils anderen Simulator angezeigt und/oder berücksichtigt werden. Soll beispielsweise mittels zwei Kranen gemeinsam ein Bauteil angehoben und an einem bestimmten Ort abgesetzt werden, können an dem einen Simulator vorgenommene Kranbewegungen und sich daraus ergebende Bauteilbewegungen an dem anderen Simulator angezeigt und ggfs. auch in Form von dynamischen Reaktionen angezeigt werden. Lässt beispielsweise der Kranführer an dem einen Simulator das gemeinsam angehobene Bauteil ruckartig ein Stück weit absenken, führt dies zu dynamischen Reaktionen auch an dem anderen simulierten Kran, die dann in Form von dynamischen Reaktionen am Führerstand des anderen Simulators wiedergegeben werden können.

Insbesondere können virtuelle Darstellungen der einen Baumaschine, die die am zugehörigen Simulator eingegebenen Steuerbefehle und sich daraus ergebende Bewegungen berücksichtigen, an der Anzeigeeinheit des jeweils anderen Simulators eingeblendet und animiert werden. Hierdurch können das Zusammenspiel und ggfs. auch sich ergebende Kollisionen gemeinsam an mehreren Simulatoren trainiert werden.

Um eine realitätsnahe Simulation des Baumaschinenbetriebs zu erreichen, kann in Weiterbildung der Erfindung vorgesehen werden, dass Maschinenreaktionen auf am Steuerstand eingegebene Steuerbefehle beispielsweise in Form von Maschinenbewegungen und/oder -verformungen nicht nur in Form einer virtuellen Darstellung auf der Anzeigevorrichtung des Simulators darzustellen, sondern in eine mit der Kran- bzw. Maschinenreaktion einhergehende, tatsächliche Bewegung des Steuerstands des Simulators umzusetzen, um dem Nutzer die dynamischen Maschinenreaktionen realitätsnäher zu vermitteln und erfahren zu lassen. Der Steuerstand, der beispielsweise einen Bedienersessel umfassen kann, ist hierzu nicht mehr statisch starr im Raum, bzw. am Boden montiert, sondern von einer Antriebsvorrichtung im Raum bewegbar, insbesondere in Abhängigkeit der von dem Bewegungsbestimmungsmodul bestimmten Bewegungen und/oder Verformung der Maschinenkomponenten bewegbar. Bestimmt das Bewegungsbestimmungsmodul Auslenkungen von Maschinenkomponenten wie beispielsweise des Kranturms durch Stellbewegungen oder Verformungen, die auf die Position der echten Kranführerkabine Einfluss hätten, wird die Antriebsvorrichtung von einer Antriebssteuervorrichtung entsprechend angesteuert, um die Bewegung der Kranführerkabine nachzubilden und den Steuerstand entsprechend zu bewegen. Wird beispielsweise am Steuerstand ein Befehl zum Verdrehen des Krans um eine aufrechte Achse eingegeben, wird der Steuerstand von der Antriebsvorrichtung entsprechend um die aufrechte Achse verdreht. Wird beispielsweise der Steuerbefehl zum Anheben einer schweren Last eingegeben, was in der Realität zu einem leichten Nicken der Kranstruktur unter leichter Verwindung des Turms führen kann, wird der Steuerstand von der Antriebsvorrichtung leicht nach vorne verfahren und/oder leicht nach vorne verkippt.

Um eine besonders realitätsnahe Nachbildung der im echten Betrieb auftretenden Steuerstandbewegungen zu ermöglichen, kann die Antriebsvorrichtung mehrachsig bewegbar ausgebildet sein und/oder sowohl rotatorische als auch translatorische Bewegungen ausführen. Insbesondere kann der Steuerstand mehrachsig beweglich gelagert sein und die Antriebsvorrichtung zumindest eine aufrechte Drehachse und zumindest eine liegende Wippachse und/oder zwei liegend ausgerichtete Translationsachsen umfassen. Um auch komplexe Steuerstandsbewegungen nachbilden zu können, kann die Antriebsvorrichtung drei Rotations- bzw. Kippachsen aufweisen bzw. dreiachsig rotatorisch arbeitend ausgebildet sein und dreiachsig translatorisch arbeitend ausgebildet sein, so dass der Steuerstand um alle drei Raumachsen verdreht bzw. verkippt und in alle drei Raumrichtungen translatorisch verfahren werden kann. Je nach zu simulierendem Kran- bzw. Maschinentyp können auch einfachere Ausbildungen der Antriebsvorrichtung mit weniger Bewegungsachsen in Betracht kommen.

Das Bewegungsbestimmungsmodul kann derart ausgebildet sein, dass die Kran- bzw. Maschinenstruktur nicht als starre, sozusagen unendlich steife Struktur betrachtet wird, sondern als elastisch verformbare und/oder nachgiebige und/oder relativ weiche Struktur angenommen wird, die - zusätzlich zu den Stellbewegungsachsen der Maschine wie beispielsweise der Auslegerwippachse oder der Turmdrehachse - Bewegungen und/oder Positionsänderungen durch Verformungen der Strukturbauteile zulässt. Die Berücksichtigung der Beweglichkeit der Maschinenstruktur infolge von Strukturverformungen unter Last oder dynamischen Belastungen ist gerade bei langgestreckten, schlanken und von den statischen und dynamischen Randbedingungen her bewusst - unter Berücksichtigung der notwendigen Sicherheiten - ausgereizten Strukturen wie bei Kranen von Bedeutung, da hier spürbare Bewegungsanteile beispielsweise für die Kranführerkabine, aber auch die Lasthakenposition durch die Verformungen der Strukturbauteile hinzukommen. Um hier eine tatsächlich realistische Schulung bzw. ein realitätsnahes Training ermöglichen zu können, berücksichtigt das Bewegungsbestimmungsmodul solche Verformungen der Maschinenstruktur unter statischen oder dynamischen Belastungen.

Insbesondere kann die Bestimmungseinrichtung zur Bestimmung solcher Strukturverformungen eine Berechnungseinheit aufweisen, die diese Strukturverformungen anhand eines gespeicherten Berechnungsmodells in Abhängigkeit der am Steuerstand eingegebenen Steuerbefehle berechnet. Ein solches Modell kann ähnlich einem Finite-Elemente-Modell aufgebaut sein oder ein Finite-Elemente-Modell sein, wobei vorteilhafterweise jedoch ein gegenüber einem Finite-Elemente-Modell deutlich vereinfachtes Modell verwendet wird.

Die vom Bewegungsbestimmungsmodul berücksichtigten Strukturteilverformungen können einerseits bei der Ansteuerung der Antriebsvorrichtung zum Bewegen des Steuerstands berücksichtigt werden, so dass der Steuerstand die durch die Strukturteilverformungen auftretenden Steuerstandbewegungen nachbildet. Alternativ oder zusätzlich können die bestimmten Strukturteilverformungen auch bei der Berechnung der virtuellen Darstellung der Maschinenumgebung und/oder der darin sichtbaren Maschinenkomponenten berücksichtigt werden, beispielsweise dahingehend, dass in der virtuellen Darstellung die Durchbiegung des Auslegers dargestellt wird oder der Horizont der Kranumgebung ein Stück nach oben gefahren wird, um ein leichtes Nach-vorne-Nicken der Kranführerkabine durch beispielsweise eine Turmverformung nachzubilden.

Um das Realitätsempfinden des Nutzers des Simulators weiter zu erhöhen, ist nach einem weiteren Aspekt vorgesehen, dass auf der Anzeigevorrichtung die von dem grafischen Simulationsmodul bereitgestellten virtuellen Darstellungen aus der Simulationswelt mit Livebildern aus dem Steuerstand, die beispielsweise Bewegungen des Fernsteuer-Einrichtung-Nutzers zeigen können, überlagert werden. Insbesondere können auf der Anzeigevorrichtung einerseits die vom grafischen Simulationsmodul generierten virtuellen Darstellungen der Maschinenumgebung und/oder der darin sichtbaren Maschinenkomponenten und andererseits am Steuerstand aufgenommene Livebilder einer Livekamera gleichzeitig und überlagert dargestellt werden. Eine solche Überlagerung von Bildern aus der Simulationswelt und Livebildern gibt dem Fernsteuer-Einrichtungnutzer ein besonders starkes Gefühl der Realitätsnähe.

Vorteilhafterweise kann hierzu als Anzeigevorrichtung eine am Kopf tragbare, insbesondere brillenartig ausgebildete Anzeigevorrichtung beispielsweise in Form einer Virtual-Reality-Brille und eine vorteilhafterweise ebenfalls am Kopf tragbare, beispielsweise als Helmkamera ausgeführte oder in die genannte Virtual-Reality-Brille integrierte Kamera Verwendung finden, die die genannten Livebilder bereitstellt, die zusammen mit der künstlich generierten, virtuellen Darstellung auf der Anzeigevorrichtung, insbesondere der Virtual-Reality-Brille, dargestellt werden. Es können jedoch auch einfachere Anzeigeeinrichtungen bspw. in Form von Bildschirmen verwendet werden.

In Weiterbildung der Erfindung kann der genannte Simulator auch als Fernsteuereinrichtung zum Fernsteuern eines "echten" Krans oder einer "echten" Baumaschine verwendet werden, wobei vorteilhafterweise zwischen der Baumaschine einerseits und dem dann eine Fernsteuer-Einrichtung bildenden Simulator andererseits eine Kommunikationsverbindung vorgesehen werden kann, über die am Steuerstand der Fernsteuer-Einrichtungs eingegebene Steuerbefehle an die Steuereinrichtung des Krans, der Baumaschine und/oder des Flurförderzeugs übertragbar sind. Der "echte" Kran bzw. das jeweils ferngesteuerte "echte" Gerät führt die am Steuerstand des Simulators bzw. der Fernsteuer-Einrichtung eingegebenen Steuerbefehle aus, gleichzeitig zeigt die am Steuerstand generierte virtuelle Darstellung der Maschinenumgebung und der darin sichtbaren Maschinenkomponenten an, wie die Maschine die Steuerbefehle umsetzt. Hierbei kann vorgesehen sein, die am echten Gerät erfassten Bewegungsparameter und Sensorsignale auf die Fernsteuer-Einrichtung rückzuspeisen und dort für die Generierung der virtuellen Darstellung der Maschinenumgebung zu verwenden, um sicherzustellen, dass tatsächlich eine der tatsächlichen Maschinenumgebung und -stellung entsprechende Darstellung auf der Anzeigevorrichtung der Fernsteuer-Einrichtung angezeigt wird.

Gemäß einem weiteren Aspekt der vorliegenden Erfindung wird auch die Steuerung einer auf der Baustelle tatsächlich verwendeten Baumaschine an das Bauwerkdatenmodell bzw. das BIM-Modell angebunden. Dabei wird anhand digitaler Informationen aus dem Bauwerkdatenmodell in die Steuerung der Baumaschine eingegriffen und/oder die Steuerung der Baumaschine parametrisiert und/oder modifiziert.

Ein solcher Eingriff in die Baumaschinensteuerung umfasst die Anpassung einer dort implementierten Arbeitsbereichsbegrenzung an Bauwerksdaten aus dem Bauwerkdatenmodell, wobei vorteilhafterweise eine zeitlich dynamische Anpassung dergestalt erfolgen kann, dass die Arbeitsbereichsbegrenzung an sich ergebende Baufortschritte angepasst werden kann bzw. nach und nach verändert werden kann.

Zusätzlich zu einer solchen automatischen Anpassung der Arbeitsbereichsbegrenzung ist auch eine Baufortschritt-Überwachung vorgesehen, bei der mittels einer geeigneten Erfassungseinrichtung mit einer

Kamera und/oder einem Scanner und/oder eines Flugobjektes der Ist-Zustand des Bauwerks und/oder dessen Umgebung erfasst und mit digitalen Informationen aus dem Bauwerkdatenmodell abgeglichen wird. Zur Erfassung des Ist-Zustands können mit einer Kamera Bauwerkskonturen erfasst und/oder vermessen, und/oder vorhandene Bauteile mittels eines Barcode-Scanners eingelesen und/oder mittels eines RFID-Lesers erfasst, und/oder Positionsdaten von Bauteilen und/oder Bauwerkskonturen mittels eines Ortsbestimmers bspw. in Form eines GPS- oder Radarmeßmoduls bestimmt werden.

Anhand des Vergleichs der erfassten Ist-Daten mit den zugehörigen relevanten BIM-Daten kann eine Bestimmung erfolgen, in welcher Bauphase sich das Bauwerk aktuell befindet. Anhand dieser Bestimmung der aktuellen Bauphase durch ein entsprechendes Bauphasen-Bestimmungsmodul können dann verschiedene unterstützende und/oder automatisierte Maßnahmen eingeleitet werden. Beispielsweise kann an einer Anzeigevorrichtung der Baumaschine angezeigt werden, welche Arbeitsschritte als nächstes auszuführen sind und/oder wohin ein an der Anlieferungsstation angeliefertes Bauteil bestimmungsgemäß zu verbringen ist. Beispielsweise kann anhand eingespielter Informationen aus dem Bauwerkdatenmodell auf einer Anzeigeeinheit im Führerstand der Baumaschine und/oder im Steuerstand der Fernsteuereinrichtung eine virtuelle Darstellung des Bauwerks in seinem jeweiligen Zustand generiert werden, in der das aktuell zu verfahrende bzw. zu verbringende Bauteil und dessen Position angezeigt wird, sodass beispielsweise ein Kranführer sehen kann, welcher Hub zu machen ist und wohin ein am Haken aufzunehmendes Bauteil verbracht werden soll.

Die Steuerung der Baumaschine kann auch ein Hubsteuerungsbaustein zur automatisierten Hubsteuerung anhand von relevanten Informationen aus dem Bauwerkdatenmodell bereitgestellt werden. Der genannte Hubsteuerungsbaustein kann dabei halbautomatisch oder vollautomatisch arbeitend ausgebildet sein, um im Zusammenspiel mit Eingabe oder Freigabe oder Bestätigungsbefehlen des Maschinenführers oder ggfs. auch ohne solche ergänzenden Steuerbefehle einen Hub automatisiert auszuführen. Hierzu kann bei halbautomatischer Ausbildung der Maschinenführer das von der Baumaschine zu verbringende Bauteil identifizieren. Alternativ kann auch eine automatisierte Bauteilerkennung erfolgen, beispielsweise mittels einer geeigneten Erfassungseinrichtung wie einem Strichcode-Leser und/oder einem RFID-Code-Erkenner und/oder einem Scanner und/oder einer Kamera, um beispielsweise eine am Kranhaken eines Krans aufgenommene Last zu identifizieren. Alternativ oder zusätzlich zu der genannten RFID-Erkennung kann auch mit einem LWID, d.h. im niederfrequenten bzw. Low Wave-Bereich arbeitenden Kennungssystem gearbeitet werden. Insbesondere kann auch mit einem sogenannten RuBee-Erkennungssystem gearbeitet werden, wobei ein solches RuBee-System bidirektional on demand kommuniziert, wobei beispielsweise in einem Frequenzbereich von größenordnungsmäßig 100-150 kHz, ggf. aber auch höher bis zu 450 kHz gearbeitet werden kann. Derartige RuBee-Tags können einen Mikroprozessor mit einem Speicherbaustein umfassen und eine IP-Adresse verwenden. Insbesondere kann die RuBee-Erkennung auch Magnetwellen verwenden und/oder induktiv kommunizieren, wobei sich die RuBee-Erkennung insbesondere durch ihre Robustheit gegenüber Störungen durch Metallteile und Feuchtigkeit auszeichnet und somit besonders für den Baumaschinen- oder Kraneinsatz geeignet ist.

Für ein erfasstes und/oder identifiziertes Bauteil kann dann anhand des Bauwerkdatenmodells und relevanter digitaler Informationen hieraus bestimmt werden, zu welchem Ort des Bauwerks das Bauteil verbracht werden soll, wobei hierfür insbesondere Positionsdaten für das jeweilige Bauteil aus dem Bauwerkdatenmodell genutzt werden können.

Das Hubsteuerungsmodul kann aus den vom Bauwerkdatenmodell bereitgestellten Daten betreffend das identifizierte Bauteil und ggfs. weiterer Bauwerkscharakteristika wie Bauwerkskonturen den Verfahrweg für den automatisierten Hub berechnen, ggfs. unter Berücksichtigung von weiteren Topographiedaten der Baustelle wie Zufahrtswegen etcetera.

Alternativ oder zusätzlich zu einem solchermaßen automatisierten Verfahren der Baumaschine durch den genannten Hubsteuerungsbaustein kann auch ein Sperrbaustein vorgesehen sein, der im Zusammenspiel mit dem Bauwerkdatenmodell einen entsprechenden Hub bzw. einen entsprechenden Arbeitsschritt der Baumaschine sperren kann, insbesondere wenn beispielsweise ein entsprechendes Bauteil bereits verbaut wurde oder ein für das Verbauen des Bauteils benötigter Anschlussbaustein noch nicht verbaut wurde.

Der genannte Sperrbaustein kann insbesondere im Zusammenspiel mit der vorgenannten Baufortschrittsüberwachung arbeiten, insbesondere dergestalt, dass anhand des zuvor erläuterten Soll-/Ist-Abgleichs des Baufortschritts ermittelt wird, ob das Bauwerk bereit ist, das jeweilige Bauteil entsprechend zu verbringen. Hierdurch können unnütze Hübe mit Bauteilen vermieden werden, die noch nicht verbaut werden können bzw. deren Einbauposition noch nicht bereit ist.

Der Sperrbaustein und/oder der vorgenannte Hubsteuerungsbaustein können in die Maschinen-Steuerungsvorrichtung integriert und/oder als Software-Tool herunterladbar und/oder einspielbar sein, oder auch in Form eines gespeicherten, separaten Bausteins an die Maschinen-Steuerungsvorrichtung angebunden werden. Vorteilhafterweise können der Sperrbaustein und/oder der Hubsteuerungsbaustein mittels digitaler Informationen aus dem Bauwerkdatenmodell parametrisiert und/oder modifiziert werden.

Die Erfindung wird nachfolgend anhand eines bevorzugten Ausführungsbeispiels und zugehörigen Zeichnungen näher erläutert. In den Zeichnungen zeigen:
- Fig. 1:: Eine schematische Darstellung einer Baumaschine in Form eines Krans, dessen Steuerung an ein Bauwerkdatenmodell angebunden ist und eine Last in einem nicht einsehbaren Bereich hinter einem Gebäude manövriert,
- Fig. 2:: Eine schematische Diagramm-Darstellung der Anbindung eines Bauwerkdatenmodells an die Steuerung des Krans aus Fig. 1 sowie an ein Maschinendatenmodell zur Unterstützung der Bauplanung sowie an einen Simulator zum Simulieren des Betriebs des Krans mit Hilfe von Daten aus dem Bauwerkdatenmodell.

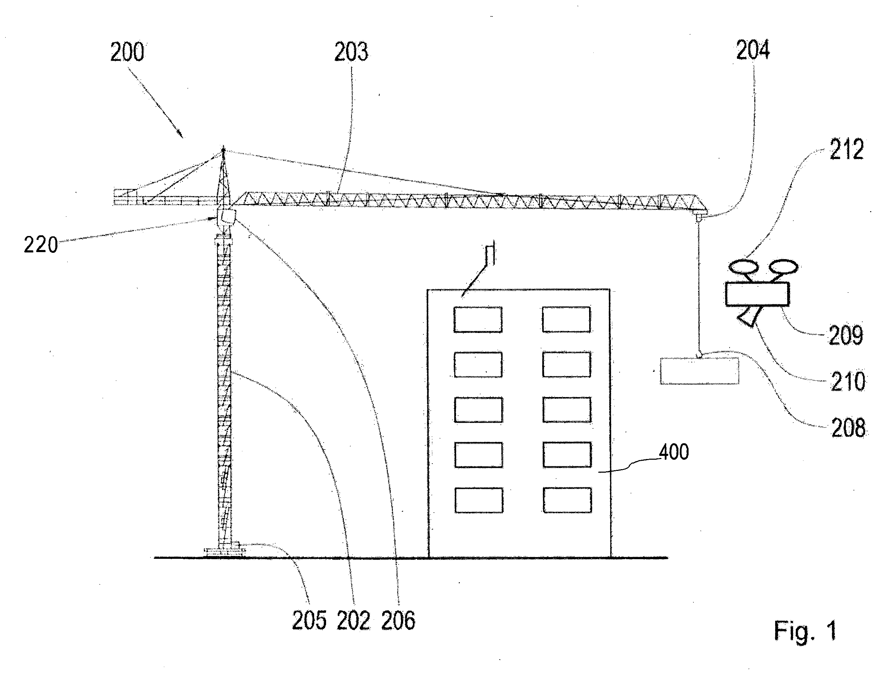

Wie Fig. 1 zeigt, kann ein Kran 200, der in noch zu erläuternder Weise an ein Bauwerkdatenmodell 300 angebunden ist, als Turmdrehkran ausgebildet sein, dessen Turm 202 einen Ausleger 203 trägt, an dem eine Laufkatze 204 verfahrbar gelagert ist. Der Ausleger 203 kann zusammen mit dem Turm 202 oder auch ohne den Turm 202 - je nach Ausbildung des Krans als Oben- oder Untendreher - um eine aufrechte Achse verdreht werden, wozu ein Drehwerksantrieb vorgesehen ist. Der Ausleger 203 könnte ggf. auch auf- und niederwippbar um eine liegende Querachse ausgebildet sein, wobei ein geeigneter Wippantrieb beispielsweise im Zusammenspiel mit der Auslegerabspannung vorgesehen sein könnte. Die genannte Laufkatze 204 kann mittels einer Katzfahrwinde oder eines anderen Katzfahrantriebs verfahren werden.

Anstelle des gezeigten Krans 200 könnte jedoch auch ein anderer Kran beispielsweise in Form eines Teleskopauslegerkrans oder auch eine Baumaschine eines anderen Typs wie beispielsweise ein Bagger Verwendung finden und an das BIM- bzw. Bauwerkdatenmodell 300 angebunden werden.

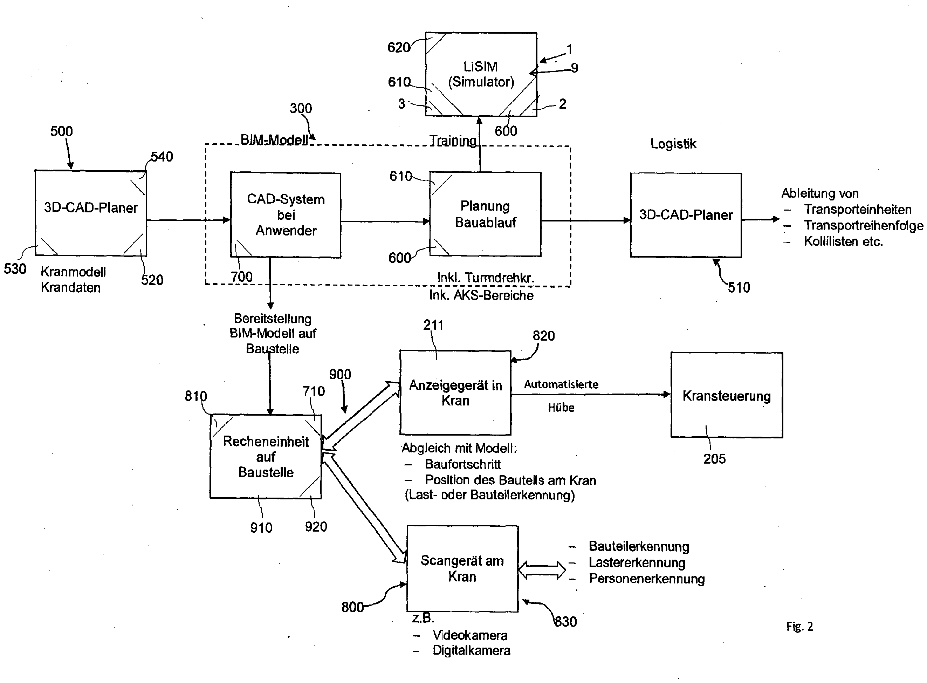

Wie Fig. 2 zeigt, kann der Kran 200 bereits in der Planungsphase berücksichtigt werden. Hierzu kann ein Baumaschinenmodell 500, das in der genannten Weise digitale Informationen über verschiedene Baumaschinen, insbesondere verschiedene Krane einschließlich des Krans 200 aus Fig. 1 enthalten kann, an ein Bauwerkdatenmodell 300 angebunden werden. Das genannte Baumaschinenmodell 500 kann in Form eines herunterladbaren Software- Tools bzw. -Bausteins bereitgestellt werden, der eine Schnittstelle aufweist, die es erlaubt, das Baumaschinenmodell 500 an das Bauwerkdatenmodell 300 anzubinden, sodass die beiden miteinander kommunizieren und Daten austauschen können.

Mit Hilfe der Anbindung des genannten Maschinendatenmodells 500 kann der Planungsprozess vereinfacht werden. Insbesondere können in der eingangs näher erläuterten Weise die Auswahl des Krans, die Positionierung des Krans relativ zu dem zu erstellenden Bauwerk und die Arbeitsbereiche des Krans 200 vorgenommen bzw. bestimmt werden. Hierzu können in das Baumaschinenmodell 500 und/oder in das Bauwerkdatenmodell 300 geeignte Software- und/oder Hardwarebausteine integriert sein, insbesondere ein Maschinen-Auswahlmodul 520, ein Aufstellort-Bestimmungsmodul 530, ein Kollisions-Bestimmungsmodul 700 und ein Arbeitsbereichs-Einstellmodul 710.

Wie Fig. 2 zeigt, kann auch ein Logistik-Modul 510 an das Bauwerkdatenmodell 300 angebunden werden, wobei das genannte Logistik-Modul 510 in das Maschinendatenmodell 500 integriert sein und/oder in Form eines Software-Bausteins herunterladbar oder auch als separater Baustein ausgebildet sein kann und vorteilhafterweise eine an das Bauwerkdatenmodell 300 angepasste Schnittstelle umfasst, sodass das Logistik-Modul 510 und das Bauwerkdatenmodell 300 miteinander kommunizieren und Daten austauschen können.

Mit Hilfe des genannten Logistik-Moduls 510 können insbesondere logistische Funktionen betreffend die ausgewählte Baumaschine automatisiert ausgeführt werden. Insbesondere können für den Transport der Baumaschine, beispielsweise des Krans 200 aus Fig. 1, benötigte Transporteinheiten festgelegt und/oder die Reihenfolge und Zeitpunkte der Transportjobs der Transporteinheiten festgelegt und/oder sog. Kolli-Listen oder Transportlisten erstellt werden.

Ferner kann ein Simulator 1 an das Bauwerkdatenmodell 300 angebunden sein, um anhand von digitalen Informationen betreffend das zu erstellende bzw. zu bearbeitende Bauwerk die von dem Simulator 1 bereitgestellte virtuelle Realität zu generieren.

Ein Steuerstand 2 des Simulators 1 kann hierbei in an sich bekannter Weise einen Bedienersitzplatz beispielsweise in Form eines Bedienersessels umfassen, um den herum diverse Eingabemittel zum Eingeben von Steuerbefehlen angeordnet sind. Die genannten Eingabemittel können beispielsweise einen Joystick, ein Touchscreen, Steuerhebel, Eingabetasten und -schalter, Drehregler, Schieberegler und Ähnliches aufweisen.

Der Bedienerplatz ist hierbei von einer Führerstandwandung umgeben, die einer Kabineneinhausung entsprechen kann und Fensterbereiche aufweisen kann, die bei echten Kranführerkabinen verglast sind, im Steuerstand 2 des Simulators 1 jedoch in einer bestimmten Farbe eingefärbt, beispielsweise mit einer grünen Folie beschichtet sind, um mittels Green-Screen-Technik eine virtuelle Maschinenumgebung einblenden zu können.

Der Steuerstand 2 ist vorteilhafterweise auf einer Bewegungsplattform montiert, mittels derer der Steuerstand mehrachsig beweglich ist. Die Bewegungsplattform ist dabei vorteilhafterweise mehrachsig beweglich ausgebildet, insbesondere um alle drei Raumachsen x, y und z verkipp- bzw. verdrehbar und entlang dieser Achsen translatorisch verschieblich.

Den Bewegungsachsen der Bewegungsplattform sind dabei Aktoren einer Antriebsvorrichtung zugeordnet, beispielsweise in Form von Elektromotoren und/oder Hydraulikzylindern und/oder Hydraulikmotoren, um den Steuerstand 2 um die bzw. entlang der genannten Achsen bewegen zu können.

Die Antriebsvorrichtung wird dabei von einer Bewegungssteuervorrichtung angesteuert, die beispielsweise durch einen Industrie-PC realisiert sein kann.

Die genannte Bewegungssteuervorrichtung kann dabei insbesondere Teil eines Bewegungsbestimmungsmoduls sein, mittels dessen Kranbewegungen und/oder Positionen und/oder Ausrichtungen von Krankomponenten wie beispielsweise des Auslegers oder des Turms und auch Verwindungen von Strukturbauteilen wie des Auslegers oder des Turms in Abhängigkeit der jeweils am Steuerstand eingegebenen Steuerbefehle bestimmt werden können. Das genannte Bewegungsbestimmungsmodul bestimmt sozusagen die Auswirkungen der eingegebenen Steuerbefehle auf den zu simulierenden Kran, d.h. welche Bewegungen, Positionen, Ausrichtungen und Verwindungen der Krankomponenten sich infolge eingegebener Steuerbefehle am zu simulierenden Kran ergeben würden und gibt entsprechende, die genannten Größen charakterisierende Bewegungssignale aus.

Das genannte Bewegungsbestimmungsmodul bestimmt die genannten Bewegungsgrößen hierbei nicht bzw. nicht vollständig durch Berechnung anhand eines Rechenmodells, sondern greift auf tatsächliche Hardwarekomponenten in Form von Antriebs- und Steuerungskomponenten zurück, die tatsächliche Bewegungen ausführen und den entsprechenden Hardwarekomponenten an einem echten Kran nachgebildet sind.

Der genannte Simulator 1 ist vorteilhafterweise dazu ausgebildet, den Betrieb der jeweils ausgewählten Baumaschine auf Basis von bereitgestellten Informationen aus dem Bauwerkdatenmodell 300 zu simulieren, wobei ein grafisches Simulationsmodul 9 zum Generieren einer virtuellen Darstellung des zu errichtenden und/oder zu bearbeitenden Bauwerks auf einer Anzeigevorrichtung 3 des Steuerstands 2 des Simulators 1 unter Zuhilfenahme der digitalen Informationen aus dem Bauwerkdatenmodell vorgesehen ist.

Vorteilhafterweise kann die Steuerung des Simulators 1 ein Bauphasenauswahlmodul 600 umfassen, mittels dessen aus dem Bauwerkdatenmodell 300 verschiedene digitale Informationen zu verschiedenen Bauphasen des Bauwerks ausgelesen bzw. identifiziert werden können, auf Basis derer die Anzeigevorrichtung 3 des Simulators 1 dann das Bauwerk in verschiedenen Bauphasen anzeigen kann, sodass ein Maschinenführer verschiedene Spezialaufgaben wie beispielsweise Sonderhübe in den verschiedenen Bauphasen trainieren kann.

Hierzu kann ein Aufgabensimulationsmodul 610 vorgesehen sein, dass mit dem grafischen Simulationsmodul 9 verbunden ist, derart dass auf der Anzeigevorrichtung 3 des Simulators zusätzlich zu dem Bauwerk auch eine virtuelle Darstellung des zu bearbeitenden Bauteils und dessen Versetzwegs eingeblendet werden kann, so wie das Bauteil zu versetzen ist.

Ohne in der Zeichnung eigens dargestellt zu sein, können auch zwei oder mehrere Simulatoren 1 an das Bauwerkdatenmodell angebunden sein, die grundsätzlich jeweils in der vorgenannten Weise ausgebildet sein können. Vorteilhafterweise ist hierbei eine übergeordnete Simulatoren-Steuervorrichtung 620 vorgesehen, die die grafischen Simulationsmodule 9 der mehreren Simulatoren 1 miteinander koordiniert, insbesondere dergestalt, dass Steuerbefehle und entsprechende Maschinenaktionen, die an dem einen Simulator erzeugt werden, auch in dem anderen Simulator berücksichtigt werden, insbesondere in der dort angezeigten virtuellen Darstellung und ggfs. auch in den erzeugten dynamischen Reaktionen des Bedienersessels, wie dies zuvor erläutert wurde.

Der genannte Simulator 1 kann vorteilhafterweise auch als Fernsteuereinrichtung genutzt werden, mittels derer der in Fig. 1 gezeigte Kran 200 ferngesteuert werden kann. Vorteilhafterweise kann die Fernsteuereinrichtung dabei auch für die Fernsteuerung mehrerer Baumaschinen, die auf derselben oder verschiedenen Baustellen aufgestellt sein können, genutzt werden, sodass die Fernsteuereinrichtung sozusagen ein Kontrollzentrum bildet.

Alternativ oder zusätzlich zu einer solchen virtuellen Darstellung kann jedoch am Steuerstand 2 auch eine echte, kameragenerierte Darstellung der Kranumgebung und/oder des Lasthakens verwendet werden. Hierzu kann am Kran 200 zumindest eine Kamera montiert sein, deren Livebilder an den Steuerstand 2 übertragen werden. Eine solche Kamera 220 kann beispielsweise an der Kranführerkabine 206 des ferngesteuerten Krans 200 montiert sein und vorteilhafterweise zumindest näherungsweise eine Blickachse haben, die der Blickachse eines Kranführers in der Kranführerkabine 206 entspricht und/oder von der Kranführerkabine 206 zum Lasthaken hin geht.

Alternativ oder zusätzlich können aber auch andere Kameras und/oder Darstellungen aus anderen Perspektiven aufgenommen und an den Steuerstand übertragen werden, um dort angezeigt zu werden. Insbesondere kann eine Flugdrohne verwendet werden, die mit zumindest einer Kamera ausgerüstet ist und ferngesteuert relativ zum Kran 200 bewegt werden kann.

Um den Lasthaken 208, der mit einem von der Laufkatze 204 ablaufenden Hubseil 207 verbunden sein kann, oder eine daran aufgenommene Last bzw. die Umgebung des Lasthakens 208 auch dann sehen zu können, wenn sich der Lasthaken 208 außerhalb des Sichtbereichs der Kranführerkabine 206 bzw. des Kranführers befindet, beispielsweise wenn - wie Fig. 1 zeigt - die Last hinter einem Gebäude abzusetzen ist, ist erfindungsgemäß eine Flugdrohne 209 vorgesehen, an der zumindest eine Kamera 210 montiert ist, mittels derer ein Kamerabild vom Lasthaken 208 und/oder der Lasthakenumgebung bereitgestellt werden kann. Das genannte Kamerabild ist vorteilhafterweise ein Live- oder Echtzeitbild im Sinne eines Fernseh- oder Videobilds und wird von der Kamera 210 der Flugdrohne 209 drahtlos zu einer Anzeigeeinheit 211 und/oder der Steuervorrichtung 205 des Krans 201 übertragen, wobei die genannte Anzeigeeinheit 211 beispielsweise ein Maschinenführerdisplay nach Art eines Tablets oder eines Bildschirms oder eines Monitors sein kann, der in der Kranführerkabine 206 montiert sein kann. Wird in der zuvor genannten Weise ein Fernsteuerstand oder eine mobile Bedieneinheit zum Steuern des Krans 200 verwendet, kann die genannte Anzeigeeinheit 211 in dem Fernsteuerstand oder an der mobilen Bedieneinheit vorgesehen sein.

Die Flugdrohne 209 ist mit einer Fernsteuereinrichtung 212 versehen, die es erlaubt, die Flugdrohne 209 fernzusteuern, insbesondere die Flugsteueraggregate wie beispielsweise Rotorblätter anzusteuern, um die Flugposition der Flugdrohne 209 fernzusteuern und/oder die Kamera 210 fernzusteuern, insbesondere hinsichtlich des Schwenkwinkels bzw. der Blickachse der Kamera 210 relativ zu dem Korpus der Flugdrohne 209 und/oder der Brennweite der Kamera 210.

Ein entsprechendes Fernsteuermodul kann in der Kranführerkabine 206 und/oder dem Fernsteuerstand oder der mobilen Bedieneinheit vorgesehen sein, beispielsweise mit entsprechenden Joysticks ausgestattet sein. Um eine einfache Bedienung zu ermöglichen, kann jedoch auch eine Sprachsteuerung und/oder eine Menüsteuerung für die Flugdrohne 209 vorgesehen sein, beispielsweise um aus mehreren vorbestimmten Relativpositionen der Flugdrohne 209 relativ zum Kran eine gewünschte Relativposition auszuwählen. Dies kann beispielsweise dadurch erfolgen, dass per Sprachsteuerung und/oder Menüsteuerung "Drohnenposition 1" eingegeben wird, die vorprogrammiert bzw. vorbestimmt in der Positionssteuervorrichtung 213 abgelegt sein kann.

Wie Fig. 2 zeigt, kann auch der Kran 200 an das Bauwerkdatenmodell 300 angebunden werden. Um das BIM- bzw. das Bauwerkdatenmodell 300 auf der Baustelle bereitzustellen, kann ein Baustellenrechner 910 vorgesehen sein, der im Bereich des zu errichtenden Bauwerks positioniert werden kann. Hierdurch können lange Datenwege und Zeitversatz reduziert werden und eine zeitversatzfreie bzw. -arme Interaktion zwischen dem Bauwerkdatenmodell 300 und dem Kran 200 realisiert werden.

Durch die Anbindung des Krans 200 an das Bauwerkdatenmodell 300 können verschiedene Kranfunktionen bzw. allgemein Steuerungsfunktionen der entsprechenden Baumaschine in Abhängigkeit digitaler Daten aus dem Bauwerkdatenmodell 300 angepasst bzw. parametrisiert werden. Hierzu können mittels der in Fig. 2 gezeigten Datenkommunikationseinrichtung 900 entsprechende digitale Informationen aus dem Bauwerkdatenmodell 300 an den Kran 200 gegeben werden. Die genannte Datenkommunikationseinrichtung 900 verbindet insbesondere den Baustellenrechner 910 mit der Steuerungsvorrichtung 205 des Krans 200.

Ein Steuerungs-Konfigurationsmodul 920, das in der Steuervorrichtung 205 des Krans 200 implementiert sein kann, aber auch in dem Baustellenrechner 910 vorgesehen sein kann, ist dazu vorgesehen, die genannten Steuerungsfunktionen der Steuervorrichtung 205 des Krans 200 entsprechend anzupassen. Insbesondere kann dieses Steuerungs-Konfigurationsmodul 920 die Arbeitsbereichsbegrenzungs-Funktion des Krans 200, die in dessen Steuervorrichtung 205 implementiert sein kann, mittels digitaler Daten aus dem Bauwerkdatenmodell 300 an verschiedene Bauphasen und dementsprechend wachsende Bauwerkswände und Hindernisse anpassen.

Unabhängig von einer solchen Anpassung der Arbeitsbereichsbegrenzung kann die Anbindung an das Bauwerkdatenmodell 300 auch dazu genutzt werden, eine automatisierte Bauphasenüberwachung zu realisieren. Hierzu kann einerseits mittels einer geeigneten Erfassungseinrichtung 800 der Ist-Zustand des Bauwerks bestimmt werden, wobei die genannte Erfassungseinrichtung 800 grundsätzlich verschieden ausgebildet sein kann. Beispielsweise kann die Erfassungseinrichtung 800 zumindest eine Kamera und/oder einen geeigneten bildgebenden Sensor umfassen, beispielsweise in Form der an der Flugdrohne 209 montierten Kamera 210 oder einer am Kran 200 montierten Kamera 220. Eine den erzeugten Bildern nachgeordnete Bildverarbeitungseinrichtung kann spezifische Charakteristika erfassen, beispielsweise Bauwerkshöhe, bebaute Grundrissfläche, Umrisskonturen oder ähnliches, welche den Baufortschritt charakterisieren. Alternativ oder zusätzlich zu solchen Kameras oder bildgebenden Sensoren können auch andere Erfassungsmittel wie beispielsweise ein Scanner oder ein RFID-Leser vorgesehen sein, um zu erfassen, ob bestimmte Bauteile bereits am Bauwerk verbaut sind oder nicht. Ein solcher Scanner oder RFID-Leser kann beispielsweise am Kranhaken 208 angebracht sein, oder auch in Form eines mobilen Geräts verwendet werden, mittels dessen verbaute Bauteile händisch gescannt werden können.

Der durch die Erfassungseinrichtung 800 erfasste Ist-Zustand des Bauwerks wird dann durch ein Bauphasen-Bestimmungsmodul 810, das beispielsweise in dem Baustellenrechner 910 implementiert sein kann, mit digitalen Informationen aus dem Bauwerkdatenmodell 300 verglichen, um aus dem Vergleich die jeweilige Bauphase zu bestimmen.

Auf Basis der bestimmten Bauphase kann der Kran 200 verschiedene Funktionen ausführen. Beispielsweise ist es bereits hilfreich, wenn die jeweils erreichte Bauphase auf einer Anzeigevorrichtung am Kran 200 angezeigt wird, sei es in dessen Kranführerkabine 206 oder am Steuerstand 2 der Fernsteuereinrichtung.

Mit Hilfe eines Steuerungs-Konfigurationsmoduls 920, das in dem Baustellenrechner 910, insbesondere aber auch in der Steuervorrichtung 205 des Krans 200 implementiert sein kann, können jedoch auch weitergehende Steuerungsfunktionen am Kran 200 adaptiert werden. Beispielsweise kann am genannten Anzeigegerät am Kran oder dessen Fernsteuervorrichtung eine virtuelle Darstellung der jeweils nächsten von der Baumaschine auszuführenden Arbeitsaufgabe angezeigt werden, beispielsweise dergestalt, dass in die virtuelle Darstellung des Bauwerks in dessen jeweiliger Bauphase das jeweils nächste zu verbauende Bauteil angezeigt und dessen Einbauposition am Bauwerk eingeblendet wird. Alternativ oder zusätzlich kann auch ein Verfahrweg in die Darstellung eingeblendet werden.

In noch vorteilhafterer Weise können auch automatisierte Hübe durch den Kran 200 ausgeführt werden, insbesondere auf Basis der vorgenannten Bauphasenüberwachung und der damit einhergehenden Bestimmung des nächsten Arbeitsschrittes. Hierzu kann eine Erfassungseinrichtung 830 vorgesehen sein, mittels derer ein im Aufnahme- bzw. Arbeitsbereich des Krans 200 befindliches Bauteil erfasst werden kann, insbesondere dahingehend, ob es das Bauteil ist, das im nächsten Arbeitsschritt verbaut werden soll. Die genannte Erfassungsvorrichtung 830 kann beispielsweise einen Barcode-Scanner oder einen RFID-Leser umfassen, der am Kranhaken angebracht sein kann. Es versteht sich jedoch, dass auch andere Erfassungsmittel verwendet werden können, um das aufzunehmende Bauteil zu identifizieren.

Wird auf diese Weise festgestellt, dass das im nächsten Arbeitsschritt zu verbauende Bauteil am Kranhaken 208 aufgenommen ist, kann das genannte Steuerungs-Konfigurationsmodul 920 die Kransteuervorrichtung 205 auf Basis der digitalen Informationen aus dem Bauwerkdatenmodell 300 dazu veranlassen, einen automatisierten Hub auszuführen, um das Bauteil an den bestimmungsgemäßen Verbauort zu verbringen.

Wie Fig. 2 andeutet, können mitteils geeigneter Scangeräte bzw. Erfassungsvorrichtungen auch andere Erkennungsfunktionen realisiert werden, beispielsweise einer Personenerkennung, insbesondere dahingehend, ob Personen im dem Last-Verfahrweg des automatisierten Hubs sind oder sich Personen unautorisiert am Kran befinden etcetera.

## Patentansprüche

1. Verfahren zum Planen und Steuern des Betriebs einer Baumaschine, insbesondere eines Krans (200), unter Verwendung eines Bauwerkdatenmodells (300), das digitale Informationen über ein zu errichtendes und/oder zu bearbeitendes Bauwerk enthält, **gekennzeichnet durch** folgende Schritte:
- Mittels eines Positionsbestimmungsmoduls automatisches Bestimmen einer geeigneten Aufstellposition einer ausgewählten Baumaschine relativ zu dem zu errichtenden und/oder zu bearbeitenden Bauwerk unter Verwendung von digitalen Informationen, die aus dem Bauwerkdatenmodell (300) einerseits und einem Maschinendatenmodell (500) andererseits ausgelesen werden, wobei beim Bestimmen der geeigneten Arbeitsposition folgende Schritte ausgeführt werden:
- automatisches Identifizieren von relevanten Informationen aus dem Bauwerkdatenmodell (300) und von relevanten Informationen aus dem Maschinendatenmodell (500), wobei die Informationen aus dem Bauwerkdatenmodell (300) zumindest Bauwerksbemaßungen und -konturen und die Informationen aus dem Maschinendatenmodell (500) zumindest den Arbeitsbereich der ausgewählten Baumaschine umfassen, und
- automatisches Abgleichen des ausgelesenen Arbeitsbereichs der ausgewählten Baumaschine mit den ausgelesenen Bauwerksbemaßungen und - konturen zum Überprüfen von einer ausreichenden Reichweite und/oder von möglichen Kollisionen,
- wobei der Arbeitsbereich der ausgewählten Baumaschine anhand der vorgenannten Kollisionprüfung automatisch begrenzt wird und das Bauwerkdatenmodell (300) durch die festgelegten Arbeitsbereichsbeschränkungen aktualisiert wird,
- wobei die Baumaschine eine Baumaschinen-Steuervorrichtung (205) zum Steuern von Arbeitsaggregaten der Baumaschine, eine Datenkommunikations-Einrichtung (900) zum Empfangen und Verarbeiten von digitalen Informationen aus dem Bauwerkdatenmodell (300), ein Steuerungs-Konfigurationsmodul (920) zur Beeinflussung zumindest einer Steuerungsfunktion der Baumaschinen-Steuereinrichtung (205) in Abhängigkeit der empfangen digitalen Informationen aus dem Bauwerkdatenmodell (300) und ein Arbeitsbereichsbegrenzungs-Einstellmodul (710) aufweist,
- wobei von einem Kollisions-Bestimmungsmodul (700) der bestimmte Aufstellungsort und der Arbeitsbereich der ausgewählten Baumaschine mit den Bauwerksbemaßungen und -konturen aus dem Bauwerksdatenmodell (300) abgeglichen werden und auf Basis des genannten Abgleichs eine Arbeitsbereichsbegrenzungsfunktion, die von der Baumaschinen-Steuervorrichtung (205) ausgeführt wird, durch das Arbeitsbereichsbegrenzungs-Einstellmodul (710) angepasst wird, um den Arbeitsbereich der Baumaschine automatisch zu begrenzen,
- wobei die Arbeitsbereichsbegrenzungs-Funktion in Abhängigkeit von Baufortschritten am zu errichtenden und/oder zu bearbeitenden Bauwerk unter Berücksichtigung von digitalen Informationen aus dem Bauwerkdatenmodell (300) automatisch aktualisiert angepasst wird, und
- wobei mittels zumindest einer Erfassungseinrichtung (800), umfassend zumindest eine Kamera (210, 220), einen Scanner und/oder eine Flugdrohne (209), an der zumindest eine Kamera (210) montiert ist, ein Ist-Zustand des Bauwerks, insbesondere das Vorhandensein bestimmter Bauwerksteile, erfasst wird, wobei von einem Baufortschritt-Bestimmungsmodul (810) der erfasste Ist-Zustand des Bauwerks mit digitalen Informationen aus dem Bauwerkdatenmodell (300) verglichen wird und in Abhängigkeit des Vergleichs bestimmte digitale Informationen aus dem Bauwerkdatenmodell (300) an die Baumaschinen-Steuervorrichtung (205) bereitgestellt werden.

2. Verfahren nach Anspruch 1, mit folgenden Schritten:
- automatisches Auswählen einer für die Errichtung und/oder Bearbeitung des Bauwerks (400) geeigneten Baumaschine (200) anhand des Bauwerkdatenmodells (300), wobei für das genannte automatische Auswählen folgende Schritte ausgeführt werden:
- Bereitstellen eines Maschinendatenmodells (500), das digitale Informationen über verschiedene Baumaschinenmodelle enthält,
- automatisches Identifizieren von relevanten Informationen aus dem Bauwerkdatenmodell (300) anhand von Kriterien, die von dem Maschinendatenmodell (500) vorgegeben werden und Maschinendaten, in denen sich die verschiedenen Baumaschinenmodelle unterscheiden, betreffen,
- automatisches Vergleichen der identifizierten Informationen aus dem Bauwerkdatenmodell (300) mit den Maschinendaten verschiedener Baumaschinen aus dem Maschinendatenmodell (500), und
- automatisches Auswählen der geeigneten Baumaschine anhand des genannten Vergleichs,
- wobei bei dem vorgenannten Schritt des Identifizierens von relevanten Informationen aus dem Bauwerkdatenmodell (300) zumindest eine der folgenden Informationen ausgelesen wird:
Bauwerkshöhe, Gewicht des schwersten zu versetzenden Bauteils, Fläche und/oder Querschnittserstreckung des Bauwerks im Aufriss, und maximale Entfernung zwischen einer Bauteil-Anlieferungsstation und einem BauteilBestimmungsort, und
wobei beim vorgenannten Vergleichen die zumindest eine ausgelesene Information aus dem Bauwerkdatenmodell (300) mit Maschinendaten aus dem Maschinendatenmodell (500), die zumindest eine der folgenden Informationen enthalten: Maschinenhubhöhe, maximales Hubgewicht und Maschinenreichweite, verglichen wird.

3. Verfahren nach einem der vorhergehenden Ansprüche, wobei die Reihenfolge und/oder die Zeitpunkte der Anlieferung von Teilen der ausgewählten Baumaschine anhand des Bauwerkdatenmodells (300) von einem mit dem Bauwerkdatenmodell (300) kommunizierenden Logistik-Modul (510) automatisch festgelegt werden, wobei für die Anlieferung der Teile der ausgewählten Baumaschine benötigte Transporteinheiten von dem Logistik-Modul (510) automatisch anhand des Bauwerkdatenmodells (300) festgelegt werden.

4. Verfahren nach einem der vorgehenden Ansprüche, wobei folgende Schritte ausgeführt werden:
- Bereitstellen von digitalen Informationen aus dem Bauwerkdatenmodell (300) an einen Simulator (1) zum Simulieren des Betriebs der Baumaschine auf Basis der bereitgestellten Informationen,
- Generieren einer virtuellen Darstellung des zu errichtenden und/oder bearbeitenden Bauwerks auf einer Anzeigevorrichtung (3) eines Steuerstands (2) des Simulators (1) unter Zuhilfenahme der bereitgestellten digitalen Informationen aus dem Bauwerkdatenmodell (300), wobei von einem Bauphasen-Auswahlmodul (600) aus dem Bauwerkdatenmodell (300) digitale Informationen zu verschiedenen Bauphasen des zu errichtenden und/oder zu bearbeitenden Bauwerks abgerufen werden und auf der Anzeigevorrichtung (3) des Simulators (1) eine virtuelle Darstellung des Bauwerks in verschiedenen Bauphasen dargestellt wird, wobei von einem Aufgaben-Simulationsmodul (610) aus dem Bauwerkdatenmodell (300) digitale Informationen betreffend das Bearbeiten und/oder Versetzen eines Bauteils ausgelesen werden und auf der Anzeigevorrichtung (3) des Simulators (1) eine virtuelle Darstellung des zu bearbeitenden Bauteils und/oder des Versetzwegs des zu bearbeitenden Bauteils relativ zu dem Bauwerk dargestellt wird.

5. Verfahren nach einem der vorhergehenden Ansprüche, wobei digitale Informationen aus dem Bauwerkdatenmodell (300) mehreren Simulatoren (1) bereitgestellt werden, wobei von grafischen Simulationsmodulen (9) der mehreren Simulatoren (1) jeweils eine virtuelle Darstellung des zu errichtenden und/oder bearbeitenden Bauwerks auf Basis der bereitgestellten Informationen aus dem Bauwerkdatenmodell (300) generiert und auf Anzeigevorrichtungen (3) der Simulatoren (1) angezeigt wird, wobei die mehreren Simulatoren (1) von einer übergeordneten Simulatoren-Steuervorrichtung (620) aufeinander abgestimmt gesteuert werden, wobei die grafischen Simulationsmodule (9) der mehreren Simulatoren (1) in Abhängigkeit von Steuerbefehlen, die an einem jeweils anderen Simulator (1) eingegeben werden, angesteuert werden, derart dass die virtuelle Darstellung an einem Simulator auch in Abhängigkeit von Baumaschinen-Betriebsvorgängen, die an einem anderen Simulator (1) simuliert werden, generiert werden.

6. Verfahren nach einem der vorhergehenden Ansprüche, wobei in Abhängigkeit der bestimmten digitalen Informationen aus dem Bauwerkdatenmodell (300), die der Baumaschine in Abhängigkeit des bestimmten Baufortschritts bereitgestellt werden, auf einer Anzeigevorrichtung (820; 211), die an der Baumaschine oder einem Steuerstand (2) zum Fernsteuern der Baumaschine angeordnet ist, eine virtuelle Darstellung des Bauwerks gemäß dem bestimmten Ist-Zustand und/oder eine virtuelle Darstellung der nächsten von der Baumaschine auszuführenden Arbeitsaufgabe dargestellt wird, wobei in Abhängigkeit des bestimmten Ist-Zustands des Bauwerks eine virtuelle Darstellung des nächsten zu bearbeitenden Bauteils und der Einbauposition des genannten Bauteils am Bauwerk in Abhängigkeit von digitalen Informationen aus dem Bauwerkdatenmodell (300) erzeugt wird.

7. Vorrichtung zum Planen und Steuern des Betriebs einer Baumaschine, insbesondere eines Krans (200), unter Verwendung eines Bauwerkdatenmodells (300), das digitale Informationen über ein zu errichtendes und/oder zu bearbeitendes Bauwerk enthält, **gekennzeichnet durch** folgende Komponenten:
- ein Aufstellort-Bestimmungsmodul (530) zum automatischen Bestimmen einer geeigneten Aufstellposition einer ausgewählten Baumaschine relativ zu dem zu errichtenden und/oder zu bearbeitenden Bauwerk unter Verwendung von digitalen Informationen aus dem Bauwerkdatenmodell (300) einerseits und digitalen Informationen aus einem Maschinendatenmodell (500) andererseits,
- ein Datenauswahl-Modul (540) zum automatischen Identifizieren und Auslesen von relevanten Informationen aus dem Bauwerkdatenmodell (300) und von relevanten Informationen aus dem Maschinendatenmodell (500), wobei die Informationen aus dem Bauwerkdatenmodell (300) zumindest Bauwerksbemaßungen sowie -konturen und die ausgelesenen Informationen aus dem Maschinendatenmodell (500) zumindest den Arbeitsbereich der ausgewählten Baumaschine umfassen, und
- ein Kollisions-Bestimmungsmodul (700) zum automatischen Abgleichen des Arbeitsbereichs der Baumaschine mit Bauwerkskonturen zum Überprüfen von einer ausreichenden Reichweite und/oder von möglichen Kollisionen, wobei ein Arbeitsbereichsbegrenzungs-Einstellmodul (710) zum Einstellen der Arbeitsbereichsbegrenzung der ausgewählten Baumaschine anhand der vorgenannten Kollisionprüfung und zum Aktualisieren des Bauwerkdatenmodells (300) durch die festgelegten Arbeitsbereichsbegrenzungen vorgesehen ist,
- wobei die Baumaschine eine Baumaschinen-Steuervorrichtung (205) zum Steuern von Arbeitsaggregaten der Baumaschine, eine Datenkommunikations-Einrichtung (900) zum Empfangen und Verarbeiten von digitalen Informationen aus dem Bauwerkdatenmodell (300), ein Steuerungs-Konfigurationsmodul (920) zum automatischen Anpassen einer von der Baumaschinen-Steuervorrichtung (205) ausgeführten Arbeitsbereichsbegrenzungsfunktion anhand der im Bauwerksdatenmodell (300) aktualisierten Arbeitsbereichsbegrenzungen und das Arbeitsbereichsbegrenzungs-Einstellmodul (710) aufweist,
- wobei das Steuerungs-Konfigurationsmodul (920) dazu ausgebildet ist, die Arbeitsbereichsbegrenzungs-Funktion in Abhängigkeit von Baufortschritten am zu errichtenden und/oder zu bearbeitenden Bauwerk unter Berücksichtigung von digitalen Informationen aus dem Bauwerkdatenmodell (300) automatisch zu aktualisieren und/oder automatisch zyklisch oder laufend anzupassen, und
- wobei zumindest eine Erfassungseinrichtung (800), umfassend zumindest eine Kamera (210, 220), einen Scanner und/oder eine Flugdrohne (209), an der zumindest eine Kamera (210) montiert ist, zum Erfassen eines Ist-Zustand des Bauwerks, insbesondere das Vorhandensein bestimmter Bauwerksteile, vorgesehen ist, wobei ein Bauphasen-Bestimmungsmodul (810) zum Vergleichen des erfassten Ist-Zustand des Bauwerks mit digitalen Informationen aus dem Bauwerkdatenmodell (300) und Bestimmen der Bauphase in Abhängigkeit des Vergleichs vorgesehen ist, wobei die Datenkommunikations-Einrichtung (900) dazu ausgebildet ist, bestimmte digitale Informationen aus dem Bauwerkdatenmodell (300) in Abhängigkeit der bestimmten Bauphase an die Baumaschinen-Steuervorrichtung (205) bereitzustellen.

8. Vorrichtung nach dem vorhergehenden Anspruch, mit folgenden Komponenten:
- ein Maschinenauswahl-Modul (520) zum automatischen Auswählen einer für die Errichtung und/oder Bearbeitung des Bauwerks (400) geeigneten Baumaschine (200) anhand von digitalen Informationen des Bauwerkdatenmodells (300),
- ein Maschinendatenmodell (500), das digitale Informationen über verschiedene Baumaschinenmodelle enthält,
- ein Datenauswahl-Modul zum automatisches Identifizieren und Auslesen von relevanten Informationen aus dem Bauwerkdatenmodell (300) anhand von Kriterien, die von dem Maschinendatenmodell (500) vorgegeben werden und Maschinendaten, in denen sich die verschiedenen Baumaschinenmodelle unterscheiden, betreffen,
- ein Vergleichs-Modul zum automatischen Vergleichen der ausgelesenen Informationen aus dem Bauwerkdatenmodell (300) mit den Maschinendaten verschiedener Baumaschinen aus dem Maschinendatenmodell (500), und
- wobei das Maschinenauswahl-Modul (520) zum automatischen Auswählen der geeigneten Baumaschine anhand des genannten Vergleichs ausgebildet ist,
- wobei die von dem Datenauswahl-Modul aus dem Bauwerkdatenmodell (300) ausgelesenen Informationen zumindest eine der folgenden Informationen umfassen:
Bauwerkshöhe, Gewicht des schwersten zu versetzenden Bauteils, Fläche und/oder Querschnittserstreckung des Bauwerks im Aufriss, und maximale Entfernung zwischen einer Bauteil-Anlieferungsstation und einem BauteilBestimmungsort, und
wobei die mit der zumindest einen ausgelesenen Information aus dem Bauwerkdatenmodell (300) verglichenen Maschinendaten aus dem Maschinendatenmodell (500) zumindest eine der folgenden Informationen enthalten: Maschinenhubhöhe, maximale Maschinentraglast und Maschinenreichweite.

9. Vorrichtung nach Anspruch 7 oder 8, wobei ein Logistik-Modul (510) zum Bestimmen der Reihenfolge und/oder der Zeitpunkte der Anlieferung von Teilen der ausgewählten Baumaschine anhand von digitalen Informationen des Bauwerkdatenmodells (300) vorgesehen ist, wobei das Logistik-Modul (410) dazu ausgebildet ist, für die Anlieferung der Teile der ausgewählten Baumaschine benötigte Transporteinheiten automatisch anhand des Bauwerkdatenmodells (300) festzulegen.

10. Vorrichtung nach einem der vorgehenden Ansprüche 7 bis 9, wobei folgende Komponenten vorgesehen sind:
- ein Simulator (1) zum Simulieren des Betriebs der Baumaschine auf Basis von bereitgestellten Informationen aus dem Bauwerkdatenmodell (300), wobei der Simulator eine Schnittstelle zum Kommunizieren mit dem Bauwerkdatenmodell (300) aufweist,
- ein grafisches Simulationsmodul (9) zum Generieren einer virtuellen Darstellung des zu errichtenden und/oder bearbeitenden Bauwerks auf einer Anzeigevorrichtung (3) eines Steuerstands (2) des Simulators (1) unter Zuhilfenahme der bereitgestellten digitalen Informationen aus dem Bauwerkdatenmodell (300), wobei ein Bauphasen-Auswahlmodul (600) zum Auswählen von digitalen Informationen zu verschiedenen Bauphasen des zu errichtenden und/oder zu bearbeitenden Bauwerks aus dem Bauwerkdatenmodell (300) vorgesehen und mit dem grafischen Simulationsmodul (9) verbunden ist derart, dass auf der Anzeigevorrichtung (3) des Simulators (1) eine virtuelle Darstellung des Bauwerks in verschiedenen Bauphasen anzeigbar ist, wobei ein Aufgaben-Simulationsmodul (610) zum Auslesen von digitalen Informationen betreffend das Bearbeiten und/oder Versetzen eines Bauteils aus dem Bauwerkdatenmodell (300) vorgesehen und mit dem grafischen Simulationsmodul (9) verbunden ist derart, dass auf der Anzeigevorrichtung (3) des Simulators (1) eine virtuelle Darstellung des zu bearbeitenden Bauteils und/oder des Versetzwegs des zu bearbeitenden Bauteils relativ zu dem Bauwerk dargestellt wird.

11. Vorrichtung nach Anspruch 10, wobei mehrere Simulatoren (1) an das Bauwerkdatenmodell (300) angebunden sind, wobei von grafischen Simulationsmodulen (9) der mehreren Simulatoren (1) jeweils eine virtuelle Darstellung des zu errichtenden und/oder bearbeitenden Bauwerks auf Basis der bereitgestellten Informationen aus dem Bauwerkdatenmodell (300) generiert und auf Anzeigevorrichtungen (3) der Simulatoren (1) angezeigt wird, wobei die mehreren Simulatoren (1) von einer übergeordneten Simulatoren-Steuervorrichtung (620) aufeinander abgestimmt gesteuert werden, wobei die grafischen Simulationsmodule (9) der mehreren Simulatoren (1) in Abhängigkeit von Steuerbefehlen, die an einem jeweils anderen Simulator (1) eingegeben werden, angesteuert werden, derart dass die virtuelle Darstellung an einem Simulator auch in Abhängigkeit von Baumaschinen-Betriebsvorgängen, die an einem anderen Simulator (1) simuliert werden, generiert wird.

12. Vorrichtung nach einem der vorhergehenden Ansprüche 7 bis 11, wobei das Steuerungs-Konfigurationsmodul (920) dazu ausgebildet ist, in Abhängigkeit der bestimmten digitalen Informationen aus dem Bauwerkdatenmodell (300), die der Baumaschine in Abhängigkeit des bestimmten Baufortschritts bereitgestellt werden, auf einer Anzeigevorrichtung (820; 211), die an der Baumaschine oder einem Steuerstand (2) zum Fernsteuern der Baumaschine angeordnet ist, eine virtuelle Darstellung des Bauwerks gemäß dem bestimmten Ist-Zustand und/oder eine virtuelle Darstellung der nächsten von der Baumaschine auszuführenden Arbeitsaufgabe anzuzeigen, wobei das Steuerungs-Konfigurationsmodul (920) dazu ausgebildet ist, in Abhängigkeit des bestimmten Ist-Zustands des Bauwerks eine virtuelle Darstellung des nächsten zu bearbeitenden Bauteils und der Einbauposition des genannten Bauteils am Bauwerk anzuzeigen.

13. Baumaschine, insbesondere Kran (200) oder Bagger, mit einer Baumaschinen-Steuervorrichtung (205) zum Steuern von Arbeitsaggregaten der Baumaschine, **gekennzeichnet durch** eine Datenkommunikations-Einrichtung (900) zum Empfangen und Verarbeiten von digitalen Informationen aus einem Bauwerkdatenmodell (300), und ein Steuerungs-Konfigurationsmodul (920) zur Beeinflussung zumindest einer Steuerungsfunktion der Baumaschinen-Steuereinrichtung (205) in Abhängigkeit der empfangen digitalen Informationen aus dem Bauwerkdatenmodell (300), wobei das Steuerungs-Konfigurationsmodul dazu ausgebildet ist, das Verfahren gemäß Anspruch 1 auszulesen.

14. Software-Programmprodukt zum Planen und Steuern des Betriebs einer Baumaschine, insbesondere eines Krans (200), unter Verwendung eines Bauwerkdatenmodells (300), das digitale Informationen über ein zu errichtendes und/oder zu bearbeitendes Bauwerk enthält, **gekennzeichnet durch** folgende codierte Programm-Mittel:
- ein Aufstellort-Bestimmungs-Programmmittel zum Bestimmen einer geeigneten Aufstellposition und/oder Überprüfen einer bestimmten Aufstellposition einer/der ausgewählten Baumaschine relativ zu dem zu errichtenden und/oder zu bearbeitenden Bauwerk unter Verwendung von digitalen Informationen aus dem Bauwerkdatenmodell (300),
- ein Datenauswahl-Programmmittel zum automatischen Identifizieren und Auslesen von relevanten Informationen aus dem Bauwerkdatenmodell (300) und von relevanten Informationen aus dem Maschinendatenmodell (500), wobei die Informationen aus dem Bauwerkdatenmodell (300) zumindest Bauwerksbemaßungen und die ausgelesenen Informationen aus dem Maschinendatenmodell (500) zumindest den Arbeitsbereich der ausgewählten Baumaschine umfassen, und
- ein Kollisions-Bestimmungs-Programmmittel zum automatischen Abgleichen des Arbeitsbereichs der Baumaschine mit Bauwerkskonturen zum Überprüfen von einer ausreichenden Reichweite und/oder von möglichen Kollisionen,
- wobei ein Arbeitsbereichsbegrenzungs-Einstell-Programmmittel zum Einstellen des Arbeitsbereichs der ausgewählten Baumaschine anhand der vorgenannten Kollisionprüfung und zum Aktualisieren des Bauwerkdatenmodells (300) durch die festgelegten Arbeitsbereichsbeschränkungen vorgesehen ist, und
- wobei das Software-Programmprodukt ausgelegt ist, das Verfahren gemäß einem der Ansprüche 1 bis 6 auszuführen.

## Claims

1. Method of planning and/or controlling the operation of a construction machine, in particular a crane (200), using a structure data model (300) that includes digital information on a structure to be erected and/or to be worked, **characterized by** the following steps:
- automatically determining, by means of a position determination module, a suitable erection position of a selected construction machine relative to the structure to be erected and/or processed using digital information read out from the structure data model (300) on the one hand and the machine data model (500) on the other hand, wherein in determining the suitable work position, the following steps are carried out:
- automatically identifying relevant information from the structure data model (300) and relevant information from the machine data model (500), wherein the information from the structure data model (300) at least comprises structure dimensions and contours and the information from the machine data model (500) at least comprises the working range of the selected construction machine, and
- automatically comparing the read-out working range of the selected construction machine with the read-out structure dimensions and contours for checking a sufficient range and/or possible collisions,
- wherein the working range of the selected construction machine is automatically restricted with reference to the aforesaid collision check and the structure data model (300) is updated by the fixed working range restrictions,
- wherein the construction machine comprises a construction machine control device (205) for controlling working units of the construction machine, a data communication device (900) for receiving and processing digital information from a structure data model (300), a control configuration module (920) for influencing at least one control function of the construction machine control device (205) in dependence on the received digital information from the structure data model (300) and a working range boundary setting module (710),
- wherein the determined installation location and the working range of the selected construction machine are compared to the structure dimensions and contours from the structure data model (300) by a collision determination module (700), and a working region boundary function executed by the construction machine control device (205) is adapted by means of the working range boundary setting module (710) in order to automatically restrict the working region of the construction machine,
- wherein the working region boundary function is automatically updated and adapted in dependence on construction progresses at the structure to be erected and/or to be worked while taking account of digital information from the structure data model (300), and
- wherein an actual state of the structure, in particular the presence of determined structure parts, is detected by means of at least one detection device (800), preferably comprising at least one camera (210, 220), a scanner and/or an aerial drone (209), having at least one camera (210) mounted to it, wherein the detected actual state of the structure is compared with digital information from the structure data model (300) by a construction progress determination module (810), and digital information from the structure data model (300) determined in dependence on the comparison is provided to the construction machine control device (205).

2. Method in accordance with claim 1, comprising the flowing steps:
- automatically selecting a construction machine (200) suitable for the erection and/or working of the structure (400) with reference to the structure data model (300), wherein the following steps are carried out for said automatic selection:
- providing a machine data model (500) that includes digital information on different construction machine models,
- automatically identifying relevant information from the structure data model (300) with reference to criteria that are specified by the machine data model (500) and relate to machine data in which the different construction machine models differ,
- automatically comparing the identified information from the structure data model (300) with the machine data of different construction machinery from the machine data model (500), and
- automatically selecting the suitable construction machine with reference to said comparison,
- wherein at least one of the following pieces of information is read from the structure data model (300) in the aforesaid step of identifying relevant information:
structure height, weight of the heaviest construction element to be moved, area and/or cross-sectional extent of the structure in elevation, and maximum distance between a construction element delivery station and a construction element destination, and
wherein, in the aforesaid comparison, the at least one piece of read information from the structure data model (300) is compared with machine data from the machine data model (500) that include at least one of the following pieces of information: machine lifting height, maximum hoist weight, and machine range.

3. Method in accordance with one of the preceding claims, wherein the order and/or the times of the delivery of parts of the selected construction machine is/are automatically fixed with reference to the structure data model (300) by a logistics module (510) communicating with the structure data model (300), wherein transport units required for the delivery of the parts of the selected construction machine are automatically determined by the logistics module (510) with reference to the structure data model (300).

4. Method in accordance with one of the preceding claims, wherein the following steps are carried out:
- providing digital information from the structure data model (300) to a simulator (1) for simulating the operation of the construction machine on the basis of the information provided, and
- generating a virtual representation of the structure to be erected and/or to be worked on a display apparatus (3) of a control station (2) of the simulator (1) with the aid of the provided digital information from the structure data model (300), wherein digital information on different construction phases of the structure to be erected and/or to be worked is accessed from the structure data model (300) by a construction phase selection module (600) and a virtual representation of the structure in different construction phases is represented on the display apparatus (3) of the simulator (1), wherein digital information relating to the working and/or moving of a construction element is read out from the structure data model (300) by a job simulation module (610) and a virtual representation of the construction element to be worked and/or of the movement path of the construction element to be worked relative to the structure is represented on the display apparatus (3) of the simulator (1).

5. Method in accordance with one of the preceding claims, wherein digital information from the structure data model (300) is provided to a plurality of simulators (1), wherein a respective virtual representation of the structure to be erected and/or to be worked is generated by graphical simulation modules (9) of the plurality of simulators (1) on the basis of the information provided from the structure data model (300) and is displayed on display apparatus (3) of the simulators (1), wherein the plurality of simulators (1) are controlled in coordination with one another by a higher ranking simulator control apparatus (620), wherein the graphical simulation modules (9) of the plurality of simulators (1) are controlled in dependence on control commands that are input at a respective other simulator (1) such that the virtual representation is generated at a simulator, also in dependence on construction machine operating procedures that are simulated at a different simulator (1).

6. Method in accordance with one of the preceding claims, wherein a virtual representation of the structure in accordance with the determined actual state and/or a virtual representation of the next work job to be carried out by the construction machine is presented on a display apparatus (820, 211) that is arranged at the construction machine or at a control station (2) for the remote control of the construction machine in dependence on the determined digital information from the structure data model (300) that is provided to the construction machine in dependence on the determined construction progress, wherein a virtual representation of the next construction element to be worked and of the installation position of said construction element at the structure in dependence on the determined actual state of the structure is generated in dependence on digital information from the structure data model (300).

7. Apparatus for planning and controlling the operation of a construction machine, in particular a crane (200), using a structure data model (300) that includes digital information on a structure to be erected and/or to be worked, **characterized by** the following components:
- an installation location determination module (530) for automatically determining a suitable installation position of a selected construction machine relative to the to the structure to be erected and/or to be worked using digital information from the structure data model (300) on the one hand and digital information from a machine data model (500) on the other hand,
- a data selection module (540) for automatically identifying and reading relevant information from the structure data model (300) and relevant information from the machine data model (500), wherein the information from the structure data model (300) at least comprises structure dimensions and the information from the machine data model (500) at least comprises the working range of the selected construction machine, and
- a collision determination module (700) for automatically comparing the working range of the construction machine with structure contours for checking a sufficient range and/or possible collisions, wherein a working range boundary setting module (710) is provided for setting the working range boundary of the selected construction machine with reference to the aforesaid collision check and for updating the structure data model (300) by the determined working range boundaries,
- wherein the construction machine comprises a construction machine control device (205) for controlling working units of the construction machine, a data communication device (900) for receiving and processing digital information from the structure data model (300), a control configuration module (920) for automatically adapting a working region boundary function executed by the construction machine control device (205) using the working range boundaries updated in the structure data module (300) and the working range boundary setting module (710),
- wherein the control configuration module (920) is configured to automatically update and/or to automatically adapt cyclically or continuously the working range boundary function in dependence on construction progresses at the structure to be erected and/or to be worked while taking account of digital information from the structure data model (300), and
- wherein at least one detection device (800) is provided, comprising at least one camera (210, 220), a scanner and/ or an aerial drone (209) to which at least one camera (210) is mounted, for detecting an actual state of the structure, in particular the presence of specific structure parts, wherein a construction phase determination module (810) is provided for comparing the detected actual state of the structure with digital information from the structure data model (300) and for determining the construction phase in dependence on the comparison, wherein the data communication device (900) is configured to provide specific digital information from the structure data model (300) to the construction machine control apparatus (205) in dependence on the determined construction phase.

8. Apparatus according to the preceding claim, comprising the following components:
- a machine selection module (520) for the automatic selection of a construction machine (200) suitable for the erection and/or working of the structure (400) with reference to digital information of the structure data model (300),
- a machine data model (500) that contains digital information on different construction machine models,
- a data selection module for automatically identifying and reading relevant information from the structure data model (300) with reference to criteria that are specified by the machine data model (500) and relate to machine data in which the different construction machine models differ,
- a comparison module for automatically comparing the read information from the structure data model (300) with the machine data of different construction machines from the machine data model (500), and
- wherein the machine selection module (520) is configured for the automatic selection of the suitable construction machine of said comparison,
- wherein the information read out from the structure data model (300) by the data selection module comprises at least one of the following pieces of information:
structure height, weight of the heaviest construction element to be moved, area and/or cross-sectional extent of the structure in elevation, and maximum distance between a construction element delivery station and a construction element destination, and
wherein the machine data from the machine data model (500) compared with the at least one piece of information read out from the structure data model (300) include at least one of the following pieces of information: machine lift height, maximum machine payload, and machine range.

9. Apparatus according to claim 7 or 8, wherein a logistics module (510) is provided for determining the order and/or the times of the delivery of parts of the selected construction machine with reference to digital information of the structure data model (300), wherein the logistics module (410) is configured to automatically determine transport units required for the delivery of the parts of the selected construction machine with reference to the structure data model (300).

10. Apparatus according to one of the preceding claims 7 to 9, wherein the following components are provided:
- a simulator (1) for simulating the operation of the construction machine on the basis of information provided from the structure data model (300), wherein the simulator has an interface for communicating with the structure data model (300),
- a graphical simulation module (9) for generating a virtual representation of the structure to be erected and/or to be worked on a display apparatus (3) of a control station (2) of the simulator (1) with the aid of the provided digital information from the structure data model (300), wherein a construction phase selection module (600) is provided for selecting digital information on different construction phases of the structure to be erected and/or to be worked from the structure data model (300) and is connected to the graphical simulation module (9) such that a virtual representation of the structure can be displayed in different construction phases on the display apparatus (3) of the simulator (1), wherein a job simulation module (610) is provided for reading digital information relating to the working and/or moving of a construction element from the structure data model (300) and is connected to the graphical simulation module (9) such that a virtual representation of the construction element to be worked and/or of the movement path of the construction element to be worked relative to the structure is represented on the display apparatus (3) of the simulator (1).

11. Apparatus according to claim 10, wherein a plurality of simulators (1) are linked to the structure data model (300) and wherein a respective virtual representation of the structure to be erected and/or to be worked is generated by graphical simulation modules (9) of the plurality of simulators (1) on the basis of the information provided from the structure data model (300) and is displayed on display apparatuses (3) of the simulators (1), wherein the plurality of simulators (1) are controlled in coordination with one another by a higher ranking simulator control apparatus (620), wherein the graphical simulation modules (9) of the plurality of simulators (1) are controlled in dependence on control commands that are input at a respective other simulator (1) such that the virtual representation is generated at a simulator, also in dependence on construction machine operating procedures that are simulated at a different simulator (1).

12. Apparatus according to one of the preceding claims 7 to 11, wherein the control configuration module (920) is configured to display, on a display device (820, 211) arranged on the construction machine or a control stand (2) for remote controlling the construction machine, depending on the determined digital information from the structure data model (300), which are provided to the construction machine depending on the determined construction process, a virtual representation of the structure in accordance with the determined actual state and/or a virtual representation of the next work job to be carried out by the construction machine, wherein the control configuration module (920) is configured to display a virtual representation of the next construction element to be worked and of the installed position of said construction element at the structure in dependence on the determined actual state of the structure.

13. Construction machine, in particular a crane (200) or an excavator, having a construction machine control apparatus (205) for controlling working units of the construction machine, **characterized by** a data communication device (900) for receiving and processing digital information from a structure data model (300), and by a control configuration module (920) for influencing at least one control function of the construction machine control apparatus (205) in dependence on the received digital information from the structure data model (300), wherein the control configuration module is configured for reading out the method in accordance with claim 1.

14. Software program product for planning and/or controlling the operation of a construction machine, in particular a crane (200), using a structure data model (300) that includes digital information on a structure to be erected and/or to be worked, **characterized by** the following encoded program means:
- an installation location determination program means for determining a suitable installation position and/or for checking a specific installation position of a/of the selected construction machine relative to the structure to be erected and/or to be worked using digital information from the structure data model (300),
- a data selection program means for automatically identifying and reading relevant information from the structure data model (300) and relevant information from the machine data model (500), wherein the information from the structure data model (300) at least comprises structure dimensions and the read information from the machine data model (500) at least comprises the working range of the selected construction machine, and
- a collision determination program means for automatically comparing the working range of the construction machine with structure contours for checking a sufficient range and/or possible collisions,
- wherein a working range boundary setting program means is provided for setting the working range of the selected construction machine with reference to the aforesaid collision check and for updating the structure data model (300) by the fixed working range restrictions, and
- wherein the software program product is adapted to execute the method in accordance with one of claims 1 to 6.

## Revendications

1. Procédé pour planifier et commander le fonctionnement d'un engin de chantier, en particulier d'une grue (200), au moyen d'un modèle de données de bâtiment (300), qui contient des informations numériques sur un bâtiment à édifier et/ou à traiter, **caractérisé par** les étapes suivantes :
- au moyen d'un module de détermination de position, détermination automatique d'une position d'installation adéquate d'un engin de chantier sélectionné par rapport au bâtiment à édifier et/ou à traiter au moyen d'informations numériques qui sont lues d'une part du modèle de données de bâtiment (300) et d'autre part d'un modèle de données d'engin (500), les étapes suivantes étant exécutées lors de la détermination de la position de travail adéquate :
- identification automatique d'informations pertinentes provenant du modèle de données de bâtiment (300) et d'informations pertinentes provenant du modèle de données d'engin (500), les informations provenant du modèle de données de bâtiment (300) comprenant au moins des cotations et des contours de bâtiment et les informations provenant du modèle de données d'engin (500) comprenant au moins la zone de travail de l'engin de chantier sélectionné, et
- recoupement automatique entre la zone de travail de l'engin de chantier sélectionné lue et les cotations et contours de bâtiment lus afin de vérifier une portée suffisante et/ou de possibles collisions,
- la zone de travail de l'engin de chantier sélectionné étant automatiquement limitée au moyen de la vérification de collision susmentionnée et le modèle de données de bâtiment (300) étant mis à jour par les restrictions de zone de travail définies,
- l'engin de chantier comportant un dispositif de commande d'engin de chantier (205) pour commander des unités de travail de l'engin de chantier, un moyen de communication de données (900) pour recevoir et traiter des informations numériques provenant du modèle de données de bâtiment (300), un module de configuration de commande (920) pour influencer au moins une fonction de commande du moyen de commande d'engin de chantier (205) en fonction des informations numériques reçues provenant du modèle de donnés de bâtiment (300) et un module de réglage de limitation de zone de travail (710),
- un recoupement entre le lieu d'installation déterminé et la zone de travail de l'engin de chantier sélectionné et les cotations et contours de bâtiment provenant du modèle de données de bâtiment (300) étant fait par un module de détermination de collision (700) et, sur la base dudit recoupement, une fonction de limitation de zone de travail, qui est exécutée par le dispositif de commande d'engin de chantier (205), étant adaptée par le module de réglage de limitation de zone de travail (710) pour limiter automatiquement la zone de travail de l'engin de chantier,
- la fonction de limitation de zone de travail étant adaptée de manière automatiquement mise à jour en fonction de l'avancement des travaux sur le bâtiment à édifier et/ou à traiter en tenant compte d'informations numériques provenant du modèle de données de bâtiment (300), et
- un état actuel du bâtiment, en particulier la présence de parties de bâtiment définies, étant détecté au moyen d'au moins un moyen de détection (800), comprenant au moins une caméra (210, 220), un scanner et/ou un drone (209), sur lequel est montée au moins une caméra (210), l'état actuel détecté du bâtiment étant comparé avec des informations numériques provenant du modèle de données de bâtiment (300) par un module de détermination d'avancement des travaux (810) et des informations numériques déterminées provenant du modèle de données de bâtiment (300) étant fournies au dispositif de commande d'engin de chantier (205) en fonction de la comparaison.

2. Procédé selon la revendication 1, comprenant les étapes suivantes :
- sélection automatique d'un engin de chantier (200) adéquat pour l'édification et/ou le traitement du bâtiment (400) au moyen du modèle de données de bâtiment (300), les étapes suivantes étant exécutées pour ladite sélection automatique :
- fourniture d'un modèle de données d'engin (500), qui contient des informations numériques sur différents modèles d'engin de chantier,
- identification automatique d'informations pertinentes provenant du modèle de données de bâtiment (300) au moyen de critères, qui sont prédéfinis par le modèle de données d'engin (500) et qui concernent des données d'engin, par lesquelles les différents modèles d'engin de chantier se différencient,
- comparaison automatique des informations identifiées provenant du modèle de données de bâtiment (300) avec les données d'engin de différents engins de chantier provenant du modèle de données d'engin (500), et
- sélection automatique de l'engin de chantier adéquat au moyen de ladite comparaison,
- au moins une des informations suivantes étant lue lors de l'étape susmentionnée d'identification d'informations pertinentes provenant du modèle de données de bâtiment (300) :
hauteur du bâtiment, poids de l'élément structural le plus lourd à déplacer, surface et/ou étendue de section du bâtiment en projection verticale et distance maximale entre un point de livraison d'élément structural et un lieu de destination d'élément structural et
l'au moins une information lue provenant du modèle de données de bâtiment (300) étant comparée lors de la comparaison susmentionnée avec des données d'engin provenant du modèle de données d'engin (500), qui contiennent au moins une des informations suivantes : hauteur de levage d'engin, poids maximal de levage et portée d'engin.

3. Procédé selon l'une des revendications précédentes, dans lequel l'ordre et/ou les moments de livraison d'éléments de l'engin de chantier sélectionné sont automatiquement définis au moyen du modèle de données de bâtiment (300) par un module de logistique (510) communicant avec le modèle de données d'engin (300), des unités de transport nécessaires pour la livraison des éléments de l'engin de chantier sélectionné étant automatiquement définies par le module de logistique (510) au moyen du modèle de données de bâtiment (300).

4. Procédé selon l'une des revendications précédentes, dans lequel les étapes suivantes sont exécutées :
- fourniture d'informations numériques provenant du modèle de données de bâtiment (300) à un simulateur (1) pour simuler le fonctionnement de l'engin de chantier sur la base des informations fournies,
- génération d'une représentation virtuelle du bâtiment à édifier et/ou à traiter sur un dispositif d'affichage (3) d'un poste de commande (2) du simulateur (1) à l'aide des informations numériques fournies provenant du modèle de données de bâtiment (300), des informations numériques concernant différentes phases de construction du bâtiment à édifier et/ou à traiter étant demandées au modèle de données de bâtiment (300) par un module de sélection de phase de construction (600) et une représentation virtuelle du bâtiment dans différentes phases de construction étant visualisée sur le dispositif d'affichage (3) du simulateur (1), des informations numériques concernant le traitement et/ou le déplacement d'un élément structural étant lues du modèle de données de bâtiment (300) par un module de simulation de tâches (610) et une représentation virtuelle de l'élément structural à traiter et/ou du trajet de déplacement de l'élément structural à traiter par rapport au bâtiment étant visualisée sur le dispositif d'affichage (3) du simulateur (1).

5. Procédé selon l'une des revendications précédentes, dans lequel des informations numériques provenant du modèle de données de bâtiment (300) sont fournies à plusieurs simulateurs (1), une représentation virtuelle du bâtiment à édifier et/ou à traiter étant respectivement générée par des modules de simulation graphique (9) des plusieurs simulateurs (1) sur la base des informations fournies provenant du modèle de données de bâtiment (300) et affichée sur des dispositifs d'affichage (3) des simulateurs (1), les plusieurs simulateurs (1) étant commandés de manière coordonnée les uns avec les autres par un dispositif de commande de simulateur (620) supérieur, les modules de simulation graphique (9) des plusieurs simulateurs (1) étant commandés en fonction d'instructions de commande, qui sont saisies sur respectivement un autre simulateur (1), de telle manière que la représentation virtuelle sur un simulateur est générée aussi en fonction de processus de fonctionnement d'engin de chantier qui sont simulés sur un autre simulateur (1).

6. Procédé selon l'une des revendications précédentes, dans lequel, en fonction des informations numériques déterminées provenant du modèle de données de bâtiment (300), qui sont fournies à l'engin de chantier en fonction de l'avancement des travaux déterminé, une représentation virtuelle du bâtiment selon l'état actuel déterminé et/ou une représentation virtuelle de la prochaine tâche de travail à exécuter par l'engin de chantier est visualisée sur un dispositif d'affichage (820 ; 211), qui est disposé sur l'engin de chantier ou un poste de commande (2) pour la commande à distance de l'engin de chantier, dans lequel, en fonction de l'état actuel déterminé du bâtiment, une représentation virtuelle du prochain élément structural à traiter et de la position de montage dudit élément structural sur le bâtiment est générée en fonction d'informations numériques provenant du modèle de données de bâtiment (300).

7. Dispositif pour planifier et commander le fonctionnement d'un engin de chantier, en particulier d'une grue (200), au moyen d'un modèle de données de bâtiment (300), qui contient des informations numériques sur un bâtiment à édifier et/ou à traiter, **caractérisé par** les composants suivants :
- un module de détermination de lieu d'installation (530) pour déterminer automatiquement une position d'installation adéquate d'un engin de chantier sélectionné par rapport au bâtiment à édifier et/ou à traiter au moyen d'une part d'informations numériques provenant du modèle de données de bâtiment (300) et d'autre part d'informations numériques provenant d'un modèle de données d'engin (500),
- un module de sélection de données (540) pour identifier et lire automatiquement des informations pertinentes provenant du modèle de données de bâtiment (300) et des informations pertinentes provenant du modèle de données d'engin (500), les informations provenant du modèle de données de bâtiment (300) comprenant au moins des cotations et des contours de bâtiment et les informations lues provenant du modèle de données d'engin (500) comprenant au moins la zone de travail de l'engin de chantier sélectionné, et
- un module de détermination de collision (700) pour faire automatiquement un recoupement entre la zone de travail de l'engin de chantier et des contours de bâtiment afin de vérifier une portée suffisante et/ou de possibles collisions, un module de réglage de limitation de zone de travail (710) étant prévu pour régler la limitation de la zone de travail de l'engin de chantier sélectionné au moyen de la vérification des collisions susmentionnée et pour mettre à jour le modèle de données de bâtiment (300) par les limitations de zone de travail définies,
- l'engin de chantier comportant un dispositif de commande d'engin de chantier (205) pour commander des unités de travail de l'engin de chantier, un moyen de communication de données (900) pour recevoir et traiter des informations numériques provenant du modèle de données de bâtiment (300), un module de configuration de commande (920) pour adapter automatiquement une fonction de limitation de zone de travail exécutée par le dispositif de commande d'engin de chantier (205) au moyen des limitations de zone de travail mises à jour dans le modèle de données de bâtiment (300) et le module de réglage de limitation de zone de travail (710),
- le module de configuration de commande (920) étant conçu pour mettre à jour automatiquement et/ou adapter automatiquement de manière cyclique ou continue la fonction de limitation de zone de travail en fonction de l'avancement des travaux sur le bâtiment à édifier et/ou à traiter en tenant compte d'informations numériques provenant du modèle de données de bâtiment (300), et
- au moins un moyen de détection (800), comprenant au moins une caméra (210, 220), un scanner et/ou un drone (209), sur lequel est montée au moins une caméra (210), étant prévue pour détecter un état actuel du bâtiment, en particulier la présence de parties de bâtiment déterminées, un module de détermination de phase de construction (810) étant prévu pour comparer l'état actuel détecté du bâtiment avec des informations numériques provenant du modèle de données de bâtiment (300) et déterminer la phase de construction en fonction de la comparaison, le moyen de communication de données (900) étant conçu pour fournir des informations numériques déterminées provenant du modèle de données de bâtiment (300) au dispositif de commande d'engin de chantier (205) en fonction de la phase de construction déterminée.

8. Dispositif selon la revendication précédente, comprenant les composants suivants :
- un module de sélection d'engin (520) pour la sélection automatique d'un engin de chantier (200) adéquat pour l'édification et/ou le traitement du bâtiment (400) au moyen d'informations numériques du modèle de données de bâtiment (300),
- un modèle de données d'engin (500), qui contient des informations numériques sur différents modèles d'engin de construction,
- un module de sélection de données pour identifier et lire automatique d'informations pertinentes provenant du modèle de données de bâtiment (300) au moyen de critères, qui sont prédéfinis par le modèle de données d'engin (500) et qui concernent des données d'engin, par lesquelles les différents modèles d'engin se différencient,
- un module de comparaison pour la comparaison automatique des informations lues provenant du modèle de données de bâtiment (300) avec les données d'engin de différents engins de chantier provenant du modèle de données d'engin (500), et
- le module de sélection d'engin (520) étant configuré pour la sélection automatique de l'engin de chantier adéquat au moyen de ladite comparaison,
- les informations lues dans le modèle de données de bâtiment (300) par le module de sélection de données comprenant au moins une des informations suivantes :
hauteur du bâtiment, poids de l'élément structural le plus lourd à déplacer, superficie et/ou étendue de section du bâtiment en projection verticale et distance maximale entre un point de livraison d'élément structural et un lieu de destination d'élément structural et
les données d'engin provenant du modèle de données d'engin (500) comparées avec l'au moins une information lue provenant du modèle de données de bâtiment (300) contenant au moins une des informations suivantes : hauteur de levage d'engin, capacité maximale de charge d'engin et portée d'engin.

9. Dispositif selon la revendication 7 ou 8, dans lequel un module de logistique (510) est prévu pour déterminer l'ordre et/ou les moments de livraison d'éléments de l'engin de chantier sélectionné au moyen d'informations numériques du modèle de données de bâtiment (300), le module de logistique (410) étant conçu pour définir automatiquement des unités de transport nécessaires pour la livraison des éléments de l'engin de chantier sélectionné au moyen du modèle de données de bâtiment (300).

10. Dispositif selon l'une des revendications précédentes 7 à 9, dans lequel les composants suivants sont prévus :
- un simulateur (1) pour simuler le fonctionnement de l'engin de chantier sur la base d'informations fournies provenant du modèle de données de bâtiment (300), le simulateur comportant une interface pour communiquer avec le modèle de données de bâtiment (300),
- un module de simulation graphique (9) pour générer une représentation virtuelle du bâtiment à édifier et/ou à traiter sur un dispositif d'affichage (3) d'un poste de commande (2) du simulateur (1) à l'aide des informations numériques fournies provenant du modèle de données de bâtiment (300), un module de sélection de phase de construction (600) étant prévu pour sélectionner des informations numériques concernant différentes phases de construction du bâtiment à édifier et/ou à traiter provenant du modèle de données de bâtiment (300) et étant relié au module de simulation graphique (9) de telle manière qu'une représentation virtuelle du bâtiment dans différentes phases de construction peut être visualisée sur le dispositif d'affichage (3) du simulateur (1), un module de simulation de tâches (610) étant prévu pour lire des informations numériques concernant le traitement et/ou le déplacement d'un élément structural dans le modèle de données de bâtiment (300) et étant relié au module de simulation graphique (9) de telle manière qu'une représentation virtuelle de l'élément structural à traiter et/ou du trajet de déplacement de l'élément structural à traiter par rapport au bâtiment est visualisée sur le dispositif d'affichage (3) du simulateur (1).

11. Dispositif selon la revendication 10, dans lequel plusieurs simulateurs (1) sont reliés au modèle de données de bâtiment (300), une représentation virtuelle du bâtiment à édifier et/ou à traiter étant respectivement générée par des modules de simulation graphique (9) des plusieurs simulateurs (1) sur la base des informations fournies provenant du modèle de données de bâtiment (300) et affichée sur des dispositifs d'affichage (3) des simulateurs (1), les plusieurs simulateurs (1) étant commandés de manière coordonnée les uns avec les autres par un dispositif de commande de simulateur (620) supérieur, les modules de simulation graphique (9) des plusieurs simulateurs (1) étant commandés en fonction d'instructions de commande, qui sont saisies sur respectivement un autre simulateur (1), de telle manière que la représentation virtuelle sur un simulateur est générée aussi en fonction de processus de fonctionnement d'engin de chantier qui sont simulés sur un autre simulateur (1).

12. Dispositif selon l'une des revendications précédentes 7 à 11, dans lequel le module de configuration de commande (920) est conçu pour, en fonction des informations numériques déterminées provenant du modèle de données de bâtiment (300), qui sont fournies à l'engin de chantier en fonction de l'avancement des travaux déterminé, afficher une représentation virtuelle du bâtiment selon l'état actuel déterminé et/ou une représentation virtuelle de la prochaine tâche de travail à exécuter par l'engin de chantier sur un dispositif d'affichage (820 ; 211), qui est disposé sur l'engin de chantier ou un poste de commande (2) pour la commande à distance de l'engin de chantier, le module de configuration de commande (920) étant conçu pour, en fonction de l'état actuel déterminé du bâtiment, afficher une représentation virtuelle du prochain élément structural à traiter et de la position d'installation dudit élément structural sur le bâtiment.

13. Engin de chantier, en particulier grue (200) ou excavatrice, comprenant un dispositif de commande d'engin de chantier (205) pour commander des unités de travail de l'engin de chantier, **caractérisé par** un moyen de communication de données (900) pour recevoir et traiter des informations numériques provenant d'un modèle de données de bâtiment (300) et un module de configuration de commande (920) pour influencer au moins une fonction de commande du moyen de commande d'engin de chantier (205) en fonction des informations numériques reçues provenant du modèle de donnés de bâtiment (300), le module de configuration de commande étant conçu pour lire le procédé selon la revendication 1.

14. Produit-programme logiciel pour planifier et commander le fonctionnement d'un engin de chantier, en particulier d'une grue (200), au moyen d'un modèle de données de bâtiment (300), qui contient des informations numériques sur un bâtiment à édifier et/ou à traiter, **caractérisé par** les moyens de programme codés suivants :
- un moyen de programme de détermination de lieu d'installation pour déterminer un lieu d'installation adéquat et/ou vérifier une position d'installation déterminée d'un / de l'engin de chantier sélectionné par rapport au bâtiment à édifier et/ou à traiter au moyen d'informations numériques provenant du modèle de données de bâtiment (300),
- un moyen de programme de sélection de données pour identifier et lire automatiquement des informations pertinentes provenant du modèle de données de bâtiment (300) et des informations pertinentes provenant du modèle de données d'engin (500), les informations provenant du modèle de données de bâtiment (300) comprenant au moins des cotations de bâtiment et les informations lues provenant du modèle de données d'engin (500) comprenant au moins la zone de travail de l'engin de chantier sélectionné, et
- un moyen de programme de détermination de collision pour faire automatiquement un recoupement entre la zone de travail de l'engin de chantier et des contours de bâtiment afin de vérifier une portée suffisante et/ou de possibles collisions,
- un moyen de programme de réglage de limitation de zone de travail étant prévu pour régler la zone de travail de l'engin de chantier sélectionné au moyen de la vérification de collision susmentionnée et pour mettre à jour le modèle de données de bâtiment (300) avec les limitations de zone de travail définies, et
- le produit-programme informatique étant conçu pour exécuter le procédé selon l'une des revendications 1 à 6.
